(19)

Europäisches Patentamt
European Patent Office
Office européen des brevets

(11) **EP 4 451 541 A1**

(12) **EUROPEAN PATENT APPLICATION**
published in accordance with Art. 153(4) EPC

(43) Date of publication:
**23.10.2024 Bulletin 2024/43**

(21) Application number: **22907003.2**

(22) Date of filing: **18.10.2022**

(51) International Patent Classification (IPC):
*H02M 7/48* [(2007.01)]     *H05H 1/46* [(2006.01)]

(52) Cooperative Patent Classification (CPC):
**H02M 7/48; H03F 3/189; H03F 3/217; H03F 3/68;
H05H 1/46**

(86) International application number:
**PCT/JP2022/038814**

(87) International publication number:
**WO 2023/112468 (22.06.2023 Gazette 2023/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **16.12.2021 JP 2021203970**

(71) Applicant: **Kyosan Electric Mfg. Co., Ltd.
Tsurumi-ku, Yokohama-shi
Kanagawa 230-0031 (JP)**

(72) Inventors:
• **KUNITAMA ,Hiroshi
Yokohama-shi, Kanagawa 230-0031 (JP)**
• **KAWAI, Satoshi
Yokohama-shi, Kanagawa 230-0031 (JP)**
• **YOSHIDA, Takuya
Yokohama-shi, Kanagawa 230-0031 (JP)**

(74) Representative: **Hoffmann Eitle
Patent- und Rechtsanwälte PartmbB
Arabellastraße 30
81925 München (DE)**

(54) **HIGH-FREQUENCY POWER SUPPLY DEVICE AND OUTPUT CONTROL METHOD FOR HIGH-FREQUENCY POWER**

(57)     In a high-frequency power control in which the output power of a high-frequency pulse output is made variable, the present invention reduces the lowering of power conversion efficiency due to an internal loss consumed inside the power supply of a high-frequency power supply device by selectively using a DC voltage control and a phase difference control depending on the output level range of an output level. The DC voltage control controls the output power by controlling a DC voltage supplied to an amplifier. The phase difference control controls the output power by controlling the phase differences φ between a plurality of control signals for controlling the amplifier. When the output level range is a high output level range, the output power is controlled by the DC voltage control, and when the output level range is a low output level range, the output power is controlled by the phase difference control.

FIG. 1

**Description**

**Technical Field**

The present invention relates to a high-frequency power supply device and an output control method for high-frequency power, and particularly to a high-frequency power supply device that outputs a high-frequency pulse output at two or more levels in multiple stages and a method for outputting the high-frequency pulse output at output levels in the multiple stages.

**Background Art**

A high-frequency power supply device conducts power amplification on a high-frequency signal by a high-frequency amplifier and outputs a high-frequency pulse output. A high-frequency pulse output with an output of 1 kw or more and within a frequency range of 27 MHz to 100 MHz is applied for industrial use in, for example, semiconductor manufacturing equipment, flat-panel display (liquid crystal panel, organic panel) manufacturing equipment, solar panel manufacturing equipment and $CO_2$ laser processing machine.

For semiconductor manufacturing processes, there is an increasing demand for a multilevel pulse function for performing pulse output in a high-frequency power supply device by changing power at multiple levels, such as two levels of high and low or three levels of high, low and zero.

Furthermore, from an aspect of productivity due to a reduction in manufacturing costs and an aspect of environment due to $CO_2$ reduction, there is increasing tendency of demands for high-efficient power conversion.

In an amplifier, instantaneous power consumption in a transistor is represented by a product of an instantaneous current and an instantaneous voltage, and a time average of a value of integral for one period of a radio frequency of the instantaneous power consumption is time-average power consumption in the transistor.

In a class-A amplifier, a current and a voltage at a drain terminal of a transistor have sine waves, of which phases are opposite to each other, and an overlapping portion of current and voltage waveforms is large in the operation of the class-A amplifier. Consequently, the efficiency of the amplifier is low. In an operation of a class-B amplifier, a drain current is biased to form a half-wave rectification waveform and makes a drain voltage to be a sine wave voltage. In the operation of the class-B amplifier in which the drain voltage is the sine wave voltage, the overlapping portion of the current and voltage waveforms is small, but is not eliminated. In order to make the amplifier more efficient, it is necessary to avoid the instantaneous current and the instantaneous voltage from existing simultaneously in a relationship between the drain voltage and the drain current.

As a method for increasing the efficiency of the amplifier, there is a known technique of power amplification according to a switching mode method for a class-D amplifier, a class-F amplifier or class-EF amplifier. It is known that a class-D amplifier increases the efficiency based on a relationship between a voltage and a current in a time domain, and the class-F amplifier and the class-EF amplifier increase the efficiency based on a relationship between a voltage and a current in a frequency domain.

As methods for controlling pulse output in a switching mode type amplifier, there are previously known DC voltage control for making a DC input voltage input to an amplifier to be variable and PWM control for controlling a pulse width of a gate signal for driving a switching element.

Since the DC voltage control is for making an input voltage to be variable to thereby drive a DC/DC converter, there are problems in size reduction and weight reduction as well as a problem of low power conversion efficiency. In order to solve these problems in the DC voltage control, a power supply device employing phase shift control has been offered (see Patent Literature 1).

The PWM control also has a problem that the control in a high-frequency domain is difficult because operating capacity of switching elements of the DC/DC converter cannot keep up with high frequencies. In order to solve the problem in the control in the high-frequency domain, another power supply device employing the phase shift control has been offered (see Patent Literature 2).

**Citation List**

**Patent Literature**

[Patent Literature 1] PCT International Publication No. 2015/097812
[Patent Literature 2] Japanese Patent Laid-Open Publication No. H6-37375

## Summary of the Invention

### Problems to Be Solved by the Invention

A method for controlling a high-frequency pulse output by employing phase shift control supplies a constant DC voltage to an amplification unit, and a phase difference $\phi$ between two amplification units is changed between a first predetermined value on a high side and a second predetermined value on a low side, thereby outputting a pulse output at two output levels. In a case of combining outputs from two amplifiers by a combiner, the phase shift control varies a phase difference $\phi$ between the two amplifiers to adjust output power. In this case, a dummy resistor implemented on the combiner in a power source causes an internal loss.

The phase shift control has a problem of low power conversion efficiency due to the internal loss which is consumed in the power source. Provided that the phase difference $\phi$ between the two amplifiers is 0 [deg] to 90 [deg] in a first constant value region in which High-side power is output and 90 [deg] to 180 [deg] in a second constant value region in which Low-side power is output, when an output level is changed, differential power that was not transmitted to an output side is consumed as an internal loss in the power source if the phase difference $\phi$ is not 0 [deg] in the first constant value region. Furthermore, the internal loss is greater than the output power with the phase difference $\phi$ in the second constant value region, and thus the power conversion efficiency is 50 % or less in a high-frequency power supply device in whole.

Thus, the high-frequency power supply device performing the phase shift control has the problem of the low power conversion efficiency caused by the internal loss which is consumed in the power source. This problem has an undesirable effect on an aspect of manufacturing costs due to a decrease in productivity and an aspect of environmental consideration by $CO_2$ reduction.

The present invention aims to solve the above-described conventional problems, and provides a high-frequency power supply device and an output control method for high-frequency power to lessen the decrease in the power conversion efficiency caused by the internal loss which is consumed in the power source in the high-frequency power supply device.

### Means for Solving the Problem

The present invention performs the high-frequency power control for making the output power of a high-frequency pulse output variable, in which DC voltage control and phase difference control are selectively used depending on a range of an output level to thereby lessen a decrease in power conversion efficiency caused by an internal loss which is consumed in a power source in the high-frequency power supply device.

The DC voltage control is for controlling output power by controlling a DC voltage supplied to an amplifier. On the other hand, the phase difference control is for controlling the output power by controlling a phase difference $\phi$ between a plurality of control signals used for controlling the amplifier.

The present invention performs the DC voltage control to control the output power when the output level is in a high-power level range while performing the phase difference control to control the output power when the output level is in a low-power level range.

In the control of the output power by the DC voltage control, the phase difference $\phi$ ($\phi$d, $\phi$s) in the phase difference control is fixed in the high-power level range, and a DC voltage Vdc supplied to the amplifier is made to be variable. In the DC voltage control, there is no consumed power due to a dummy resistor inside the high-frequency power supply device, so that the problems of an internal loss consumed in a power source and low conversion efficiency of the power are eliminated, and thus high efficiency can be achieved. However, there is a drawback of a necessity to upsize the device in order to make the DC voltage control to be compatible with all ranges of the output level.

On the other hand, the control of the output power by the phase difference control limits a target output level to be within the low-output level range. It can keep the output level passing the dummy resistor in the high-frequency power supply device at the low level, so that the internal loss occurring in the dummy resistor can be reduced, thereby achieving the high-efficiency.

The phase difference control of the invention includes two control modes.

A first phase difference control is PWM control that modulates a pulse width by using a control signal phase difference $\phi$d which is a phase difference between the control signals. The PWM control is performed to vary a duty ratio (Duty) of a pulse signal for driving a switching element. In the first phase difference control (PWM control), the dummy resistor of the high-frequency power supply device does not cause the internal loss, so that the high efficiency can be achieved.

A second phase difference control is phase shift control (PS control) that uses a pair of control signals as one set, each signal being input to each of two amplifiers, and uses a phase difference between the sets of the control signals input to the two amplifiers as control signal set phase difference $\phi$s, thereby shifting the control signal set phase difference

ϕs. The phase shift control is performed to combine outputs from the two amplifiers to thereby control the resultant output power. The phase shift control (PS control) causes a loss in the dummy resistor.

In the phase difference control, the PWM control of the first phase difference control and the phase shift control (PS control) of the second phase difference control are selectively used depending on the high-low state of the output level in the low-output level range.

In the aspect of selectively using the PWM control and the phase shift control (PS control), the low-output level range is divided into a high-level part and a low-level part so that the output power is variable on the high-level part by the PWM control while being variable on the low-level part by the phase shift control (PS control).

The phase shift control (PS control) has a property of decreasing in the power conversion efficiency due to the internal loss consumed in the power source. By taking into consideration this property, the present invention applies the phase shift control (PS control) in the low-level part where the ratio of the internal loss is large comparing to the output power, so as to reduce the degree of the internal loss comparing to the degree in the case where the phase shift control is applied in the high-level part.

The aspect of selectively using the PWM control and the phase shift control (PS control) can expand the range of the controllable output level toward the low-level part, and thus the internal loss can be reduced in all of the output level ranges, thereby achieving the high efficiency.

The DC voltage control and the phase difference control of the present invention can vary the output power continuously in each output level range. In addition to that, at the time of changing from the DC voltage control to the phase difference control or from the phase difference control to the DC voltage control, the output levels at the end in both controls are matched to each other to make the output power to be continuously variable without being discontinuous in all of the output level ranges.

The present invention has an aspect of (A) a high-frequency power supply device and an aspect of (B) an output control method for high-frequency power.

(A) Aspect of High-Frequency Power Supply Device

The aspect of the high-frequency power supply device of the present invention includes a pair of amplifiers, and a combining unit that combines amplifier outputs of the pair of amplifiers to generate output power with a high-frequency pulse. A control unit that controls the output power includes a first control section that performs DC voltage control for controlling a DC voltage Vdc supplied to the pair of amplifiers to thereby control the output power, and a second control section that performs phase difference control on the output power by using a phase difference ϕ (ϕd, ϕs) between control signals for controlling the amplifier outputs of the pair of amplifiers. Depending on an output level of the output power, a control mode is changed between the DC voltage control by the first control section and the phase difference control by the second control section.

The high-frequency power supply device of the present invention includes, as constituent elements for the first control section and the second control section, a pair of amplifiers, a combining unit that combines amplifier outputs from the pair of the amplifiers to generate output power with a high frequency pulse, a power control unit that computes a DC voltage command value Vref* used for the DC voltage control and a phase difference command value ϕ* (ϕd*, ϕs*) used for the phase difference control in controlling the output power of the high frequency pulse output, a DC voltage control unit that performs the DC voltage control on the DC voltage Vdc supplied to the pair of the amplifiers based on the DC voltage command value Vref , and a control signal generation unit that generates control signals used for the phase difference control on the pair of the amplifiers based on the phase difference command value ϕ* (ϕd*, ϕs*).

The power control unit performs at the output level of the output power:

(a) computation of the DC voltage command value Vref* for the DC voltage control for the high-output level range; and
(b) computation of the phase difference command value ϕ* (ϕd*, ϕs*) for the phase difference control for the low power level range, so as to change the mode between the DC voltage control and the phase difference control depending on the output level of the output power to control the output power.

The first control section that performs the DC voltage control consists of a DC voltage computation unit that computes the DC voltage command value Vref* in the power control unit and a DC voltage control unit that performs the DC voltage control based on the DC voltage command value Vref . The second control section that performs the phase difference control consists of a phase difference computation unit that computes the phase difference command value ϕ* (ϕd*, ϕs*) in the power control unit and a control signal generation unit that generates control signals having a phase difference ϕ (ϕd, ϕs) based on the phase difference command value ϕ* (ϕd*, ϕs*).

The control signal used in the present invention can be a signal in single-ended signaling or in differential signaling, and the signal in the differential signaling is preferable in a high-frequency domain. In a case where a switching element of an amplifier is driven at a high frequency that is over tens of Mhz to 100 Mhz, it is necessary to suppress noise in a signal in order to transmit a phase difference and duty information properly. It is difficult to satisfy noise resistance requirements in a signal in the single-ended signaling. By contrast, the signal in the differential signaling is suitable as a control signal for controlling a high-frequency pulse output because the signal in the differential signaling, which consists of a pair of signals with opposite phases, has high noise resistance.

(1) Power Control Unit

The power control unit determines the output level of the output power based on the output power command value, and further determines which control of the DC voltage control or the phase difference control is to be employed depending on the high and low-output levels, thereby changing between the DC voltage control and the phase difference control depending on whether the output level is in the high-output level range or the low-output level range.

On the basis of a difference between an output power command value FWD_ref* and an output power feedback value FWD_FB, the power control unit performs the DC voltage control when the output level is in the high-output power level range while performing the phase difference control when the output level is in the low-output level range.

(a) In the high-output power level range, the DC voltage control is performed to compute the DC voltage command value Vref* based on the difference between the output power command value FWD_ref* and the output power feedback value FWD_FB. The DC voltage command value Vref* is a reference voltage for the DC voltage Vdc applied to the amplifier, and the DC voltage Vdc is applied to the amplifier so that the amplifier outputs output power FWD which is based on the DC voltage command value Vref*.

(b) In the low-output level range, the phase difference control is performed to compute the phase difference command value $\phi^*$ ($\phi d^*$, $\phi s^*$) based on the difference between the output power command value FWD_ref* and the output power feedback value FWD_FB. The phase difference command value $\phi^*$ ($\phi d^*$, $\phi s^*$) is used as an operation volume for generating the control signal in the control signal generation unit based on the phase difference command value $\phi^*$ to drive the amplifier by a drive signal based on the control signal with the phase difference $\phi$ ($\phi d$, $\phi s$), thereby allowing the amplifier to output the output power FWD based on the output power command value FWD_ref*.

(2) DC Voltage Control Unit

The DC voltage control unit varies the DC voltage Vdc supplied to the amplifier in the high-output level range based on the DC voltage command value Vref* obtained by the DC voltage control performed by the power control unit, so as to control the output power of the amplifier.

The DC voltage control unit includes an AD/DC converter that determines a manipulated variable $\alpha$ for performing the control based on a difference between the feedback voltage Vdc_FB and the DC voltage command value Vref* such that the DC voltage Vdc to be applied to the amplifier matches the DC voltage command value Vref , and uses the manipulated variable $\alpha$ for controlling the AD/DC converter of the amplifier to vary the DC voltage Vdc. The AD/DC converter is controlled with the manipulated variable $\alpha$ based on the DC voltage command value Vref* to thereby control the output voltage of the DC voltage Vdc.

(3) Control Signal Generation Unit

The control signal generation unit controls the phase difference $\phi$ ($\phi d$, $\phi s$) between the pair of control signals input to the two amplifiers in the low-output level range based on a phase difference command value $\phi^*$ ($\phi d^*$, $\phi s^*$) obtained by the phase difference control performed by the power control unit. The phase difference $\phi$ ($\phi d$, $\phi s$) between the control signals corresponds to the phase difference command value $\phi^*$ ($\phi d^*$, $\phi s^*$) obtained by the phase difference control by the power control unit.

In a case of using a signal in the differential signaling as the control signal, the signal in the differential signaling consists of a pair of signals, a P-signal and an N-signal, of which phases are opposite to each other, so that a pair of the control signals having the phase difference $\phi$, each of which is input to each amplifier, consists of two pairs of signals, namely four signals in total.

The phase difference control includes the computation of the phase difference command value $\phi^*$ ($\phi d^*$, $\phi s^*$) performed by the power control unit and the generation of the control signals having the phase difference $\phi$ ($\phi d$, $\phi s$) based on the phase difference command value $\phi^*$ ($\phi d^*$, $\phi s^*$) performed by the control signal generation unit. The control signal generation unit generates control signals having the phase difference $\phi$($\phi d$, $\phi s$) based on the phase difference command value $\phi^*$ ($\phi d^*$, $\phi s^*$) computed by the power control unit.

Thus, the phase difference control of the present invention consists of the computation of the phase difference command value $\phi^*$ ($\phi d^*$, $\phi s^*$) performed by the power control unit and the generation of the control signals having the phase difference φ (φd, φs) performed by the control signal generation unit based on the phase difference command value φ* (φd*, φs*).

The control aspect employed to the phase difference control by the phase difference computation unit and the control signal generation unit includes control aspects of (a) PWM control (duty control) and (b) phase shift control (PS control).

The control signal generation unit includes a function of generating the control signals by the phase difference control using the PWM control and the phase shift control (PC control), and generates the control signals having the phase difference φ (φd, φs) in the low-output level range based on the phase difference command value φ* (φd*, φs*) computed by the power control unit. The control signals generated by the control signal generation unit are converted into gate signals in a driver so that drive control is performed on the switching elements of the amplifier to control the output power.

The phase difference control has several types of control aspects.

(a) First control aspect of phase difference control

A first control aspect of the phase difference control is the PWM control (duty control). For the output power on the high-output level side in the low-output level range, the PWM control is performed by using a control signal phase difference command value φd* to generate control signals having a control signal phase difference φd to control the output power.

Since the pair of the control signals is used for one amplifier, two pairs of the control signals are generated for a pair of the amplifiers. In the case where the control signals are formed by signals in the differential signaling, the number of the control signals to be input to the pair of the amplifiers is four.

The control signal phase difference φd defined based on the control signal phase difference command value φd* defines a duty ratio (Duty) of a gate signal of each switching element of the amplifier so that a high-frequency pulse output is controlled by the PWM control (duty control).

(b) Second control aspect of phase difference control

A second control aspect of the phase difference control is the phase shift control (PS control). For the output power on the low-output level side in the low-output level range, the phase shift control is performed by using a control signal set phase difference command value φs* to generate control signals having a control signal set phase difference φs to thereby control the output power.

The phase shift control uses the pair of the control signals to be input to each amplifier as a set to control the control signal set phase difference φs between the sets of the control signals to be input to the two amplifiers, and uses the control signal set phase difference φs to control a phase difference between the gate signals of the two amplifiers to thereby control output power of a high-frequency pulse output that is generated by combining amplifier outputs from the two amplifiers.

(c) Third control aspect of phase difference control

A third control aspect of the phase difference control is a combination of the PWM control (duty control) of the first control aspect and the phase shift control (PS control) of the second control aspect.

The power control unit performs computation to obtain a phase difference command value φ* that includes a pair of the control signal phase difference command values φd* to be input to each amplifier and the control signal set phase difference command value φs* consisting of a pair of the control signals to be input to each amplifier.

The control signal generation unit generates control signals having the phase difference φ (φd, φs) based on the phase difference command value φ* (φd*, φs*) obtained by computing the phase difference by the power control unit, and selectively performs the PWM control and the phase difference control of the phase shift control according to the output level to thereby control the high-frequency pulse output power.

In the phase difference control, the pulse width controlled by the PWM control defines a pulse width of the gate signal. The minimum pulse width of the gate signal is limited by operating characteristics of the switching element. Thus, the minimum pulse width obtained by narrowing the pulse width by the PWM control is also limited, and that may cause a problem in the PWM control for the pulse width narrower than the minimum pulse width.

The present invention narrows the pulse width of the gate signal by the PWM control until the pulse width to be narrowed by the PWM control becomes minimum, or by the phase shift control for a pulse width shorter than the minimum pulse width. This enables the control of the output power to an arbitrary low-level range.

(B) Aspect of Output Control Method for High-Frequency Power

An aspect of the output control method for high-frequency power of the present invention is a control method for high-frequency power that controls a pair of amplifiers to vary high-frequency pulse output power, thereby changing DC voltage control and phase difference control according to an output level.
(a) In a high-output level range where the output level is high, the DC voltage control for controlling a DC voltage supplied to the pair of the amplifiers is performed to control the output power.
(b) In a low-output level range where the output level is low, the phase difference control for controlling a phase difference $\phi$ ($\phi d$, $\phi s$) between a plurality of control signals input to the pair of the amplifiers is performed to control the output power.

(1) DC Voltage Control

The DC voltage control determines a DC voltage command value Vref* in the high-output level range, and varies a DC voltage Vdc supplied to each amplifier based on the determined DC voltage command value Vref* to control the output power of the amplifier.

(2) Phase Difference Control

The phase difference control is adopted in the low-output level range. The low-output level range is divided into a high-level part and a low-level part so that the output power on the high-level part is controlled by PWM control (duty control) using a control signal phase difference $\Phi d$, and the output power on the low-level part is controlled by phase shift control (PS control) using a control signal set phase difference $\phi s$.
The phase difference control includes a phase difference computation step for obtaining a phase difference command value $\phi^*$ ($\phi d^*$, $\phi s^*$) and a control signal generation step for generating the phase difference $\phi$ ($\phi d$, $\phi s$) based on the phase difference command value $\phi^*$ ($\phi d^*$, $\phi s^*$).
In the phase difference computation step, phase difference computation is performed to compute the phase difference command value $\phi^*$ ($\phi d^*$, $\phi s^*$) based on a difference between an output power command value and an output power feedback value. The control signal phase difference control generates control signals having the phase difference $\phi$ ($\phi d$, $\phi s$) based on the phase difference command value $\phi^*$ ($\phi d^*$, $\phi s^*$) obtained by the phase difference computation. Then, the control signals are used to drive each amplifier to control the output power.
The phase difference control is applied to a first control aspect by (a) the PWM control (duty control) and a second control aspect by (b) the phase shift control (PS control). The phase difference control is applied to the low-output level range to perform drive control on the switching elements of the amplifiers by using gate signals that are generated based on the control signals, thereby controlling the output power.

(a) First control aspect of phase difference control

In the first control aspect, the phase difference $\phi$ is a control signal phase difference $\phi d$ between the control signals input to the amplifiers, and the phase difference control is performed to control a pulse width by the control signal phase difference $\Phi d$, and the PWM control for controlling a duty ratio (Duty) of a gate signal of each switching element of the amplifiers is performed to control the output power of the high-frequency pulse output.

(b) Second control aspect of phase difference control

In the second control aspect, the phase difference $\phi$ is a control signal set phase difference $\phi s$ between the control signals input to the amplifiers, and the phase difference control is a control aspect employing the phase shift control (PS control).

(c) Third control aspect of phase difference control

A third control aspect of the phase difference control is a combination of the PWM control (duty control) of the first control aspect and the phase shift control (PS control) of the second control aspect.
This phase difference control selectively uses the PWM control and the phase shift control (PS control) according to an output level. In the low-output level range to which the phase difference control is applied, the PWM control using the control signal phase difference $\phi d$ is performed on the high-output level part to control the output power, and the phase shift control using the control signal set phase difference φs is performed on the low-output level part to control the output power.

Phase difference computation is performed to obtain a phase difference command value φ* having a control signal phase difference command value φd* input to each amplifier and a control signal set phase difference command value φs* input to each amplifier, and the phase difference control is performed by using the obtained phase difference command value φ* (φd*, φs*) to generate control signals having the phase difference φ (φd, φs).

In the phase difference control, a pulse width controlled by the PWM control defines the pulse width of the gate signal. The pulse width of the gate signal is limited by the operating characteristics of the switching element. Thus, the minimum pulse width obtained by narrowing the pulse width by the PWM control is also limited, and that may cause a problem in the PWM control for the pulse width narrower than the minimum pulse width.

The present invention narrows the pulse width of the gate signal by the PWM control until the pulse width to be narrowed by the PWM control becomes minimum, or by the phase shift control (PS control) for a pulse width shorter than the minimum pulse width. This enables the control in a low-level range where the PWM control is difficult, so that the output power can be controlled to an arbitrary low-level range.

(3) Mode of Phase Difference Control between Control Signals by Power Control Unit

The phase difference control between the control signals by the power control unit has multiple modes, namely a first mode to a third mode.

(a) First mode

In the first mode, the power control unit performs the phase difference control to obtain the control signal phase difference command value φd* between a pair of control signals of the control signals to be input to each amplifier, based on a comparison of an output power feedback value FWD_FB of a high-frequency pulse output and an output power command value FWD_ref*.

(b) Second mode

In the second mode, the power control unit adjusts the control signal phase difference command value φd* between a pair of signals of the control signals in each amplifier based on a comparison between amplifier outputs of the amplifiers, so as to perform the phase difference control for balancing the amplifier outputs of two amplifiers.

(3) Third mode

In the third mode, the power control unit performs the phase difference control in each of the two amplifiers to adjust control signal phase difference command values Φda* and φdb* that equalize the degree of the phase difference between a first control signal phase difference φda between a pair of control signals input to one of the amplifiers and a second control signal phase difference φdb between a pair of control signals input to the other amplifier.

(4) Mode of Phase Difference Control between Control Signal Sets by Power Control Unit

The power control unit determines a phase difference command value φs* between two signal sets based on a comparison of the output power feedback value FWD_FB of the high-frequency pulse output and the output power command value FWD_ref*. Then, the phase difference control unit performs the phase shift control based on the phase difference command value φs* between the control signal sets to generate control signals having a phase difference φs.

(C) Mode Commonly Applied to High-Frequency Power Supply Device and Output Control Method for High-Frequency Power

(a) Mode of PWM Control

The PWM control has multiple control modes, namely a first control mode to a third control mode.

(a) First control mode

The first control mode of the PWM control determines a control signal phase difference command value φd* between a pair of control signals input to each amplifier based on a comparison of the output power feedback value FWD_FB of the high-frequency pulse output and the output power command value FWD_ref*.

(b) Second control mode

The second control mode of the PWM control adjusts the control signal phase difference command value $\phi$d* between the pair of control signals in each amplifier based on a comparison of amplifier outputs of the amplifiers, so as to balance the amplifier outputs of a pair of the amplifiers.

(c) Third control mode

The third control mode of the PWM control performs the phase difference control in each of the pair of the amplifiers to adjust a control signal phase difference command values $\Phi$da* and $\phi$db* that equalize the degree of the phase difference between a first control signal phase difference $\phi$da between a pair of control signals to be input to one of the amplifiers and a second control signal phase difference $\phi$db between a pair of control signals to be input to the other amplifier.

(2) Control Mode of Phase Shift Control (PS Control)

The phase shift control determines a control signal set phase difference command value $\phi$s* between two control signal sets based on a comparison of the output power feedback value FWD_FB of the high-frequency pulse output and the output power command value FWD_ref*.

(3) Form of Control Signal

In the present invention, the use of a form of a signal in the differential signaling, in which the phases of control signals are opposite to each other, can enhance noise resistance in driving the switching elements of the amplifiers. It is desirable to use the signal in the differential signaling as a control signal in the present invention, but does not preclude operations using a single-ended signal.

**Effect of the Invention**

As described above, according to the present invention, the high-frequency power supply device and the output control method for high-frequency power can reduce a decrease in power conversion efficiency caused by internal losses consumed in the power source of the high-frequency power supply device.

**Brief Description of the Drawings**

Figure 1 is a schematic diagram of control according to the present invention;
Figure 2 illustrates how to selectively use DC voltage control and phase difference control according to the present invention;
Figure 3 illustrates a relationship between power control and output power according to the present invention;
Figure 4 illustrates another relationship between the power control and the output power according to the present invention;
Figure 5 illustrates a relationship between a duty ratio Duty and an output voltage;
Figure 6 illustrates a relationship between PWM control and the output power;
Figure 7 is a flowchart illustrating a mode of an output control method for high-frequency power of the present invention;
Figure 8 illustrates a configuration example of a high-frequency power supply device of the present invention;
Figure 9 illustrates another configuration example of the high-frequency power supply device of the present invention;
Figure 10 illustrate yet another configuration example of the high-frequency power supply device of the present invention;
Figure 11 illustrates a configuration example of a main part of a power control unit of the present invention;
Figure 12 is a signal diagram illustrating, such as, control signals and gate signals in the high-frequency power supply device of the present invention;
Figure 13 is another signal diagram illustrating, such as, the control signals and the gate signals in the high-frequency power supply device of the present invention;

Figure 14 is yet another signal diagram illustrating, such as, the control signals and the gate signals in the high-frequency power supply device of the present invention; and

Figure 15 is a signal diagram illustrating an example of parallel connection in the high-frequency power supply device of the present invention.

**Best Mode for Carrying Out the Invention**

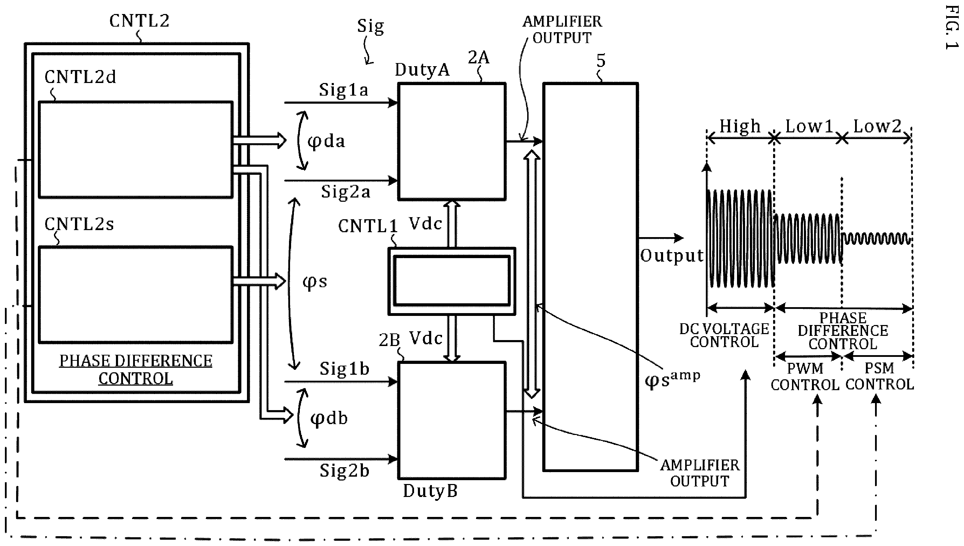

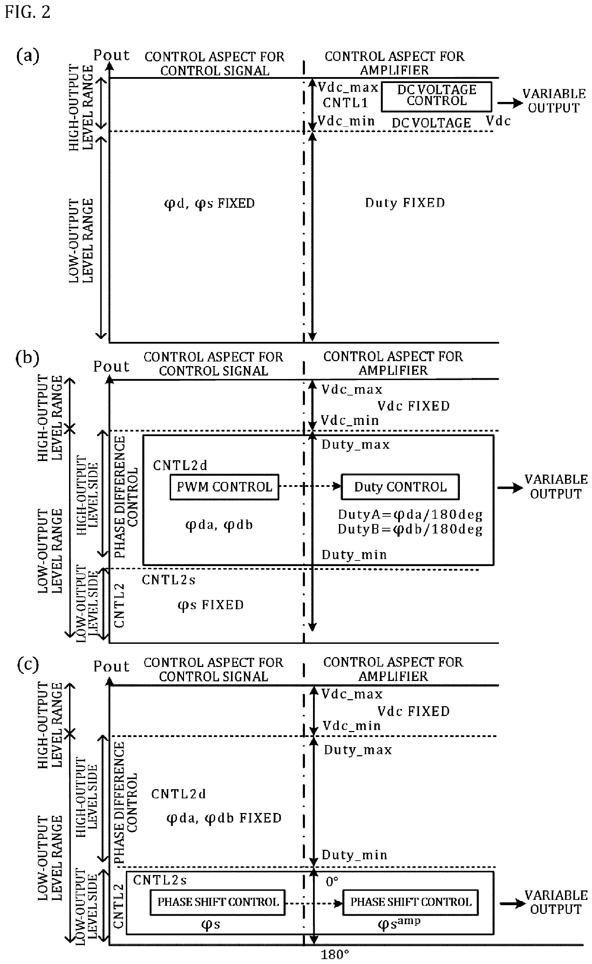

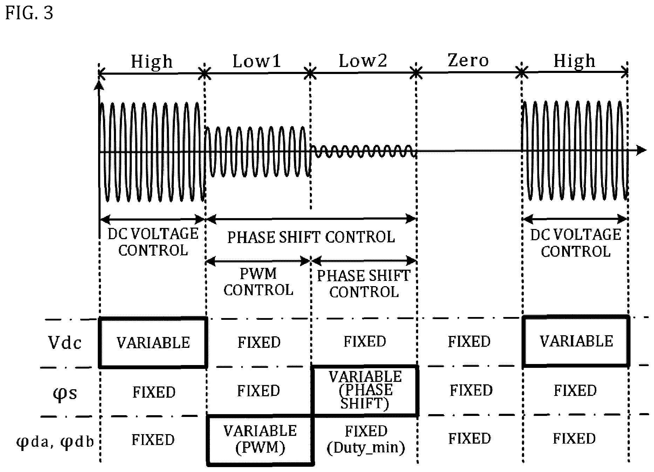

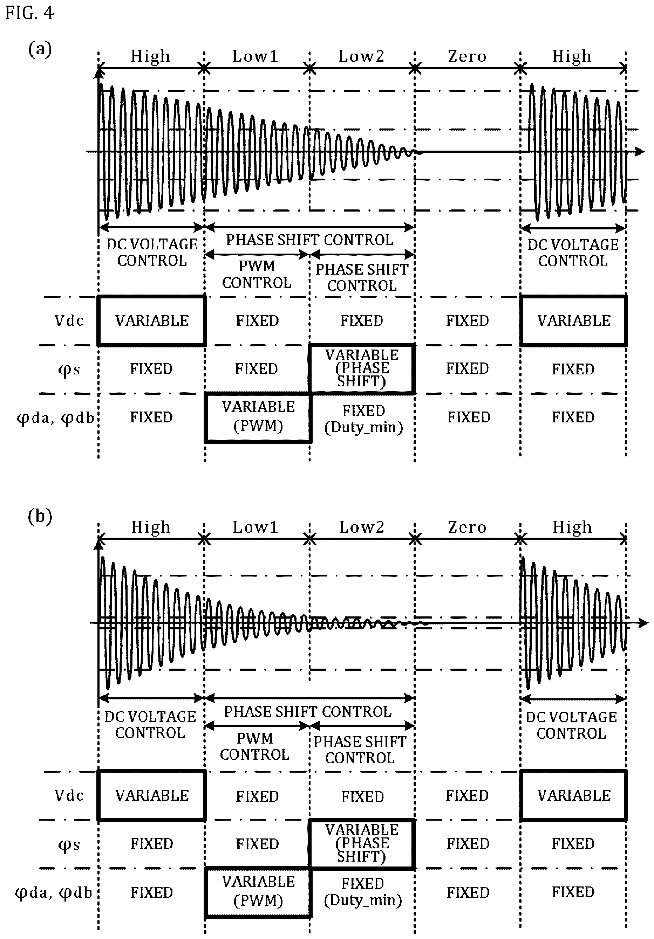

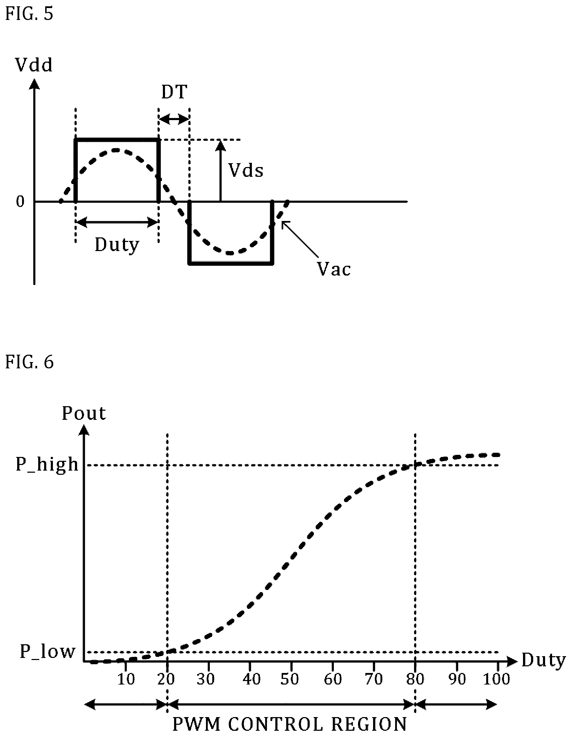

An outline of the present invention will be described by referring to FIGS. 1 and 2. In regard to power control according to the present invention, a description will be made about a relationship between the power control and output power according to the invention by referring to FIGS. 3 and 4, a description will be made about a relationship between an internal loss and the output power by referring to FIG. 5, and a description will be made about a relationship between PWM control and the output power by referring to FIG. 6.

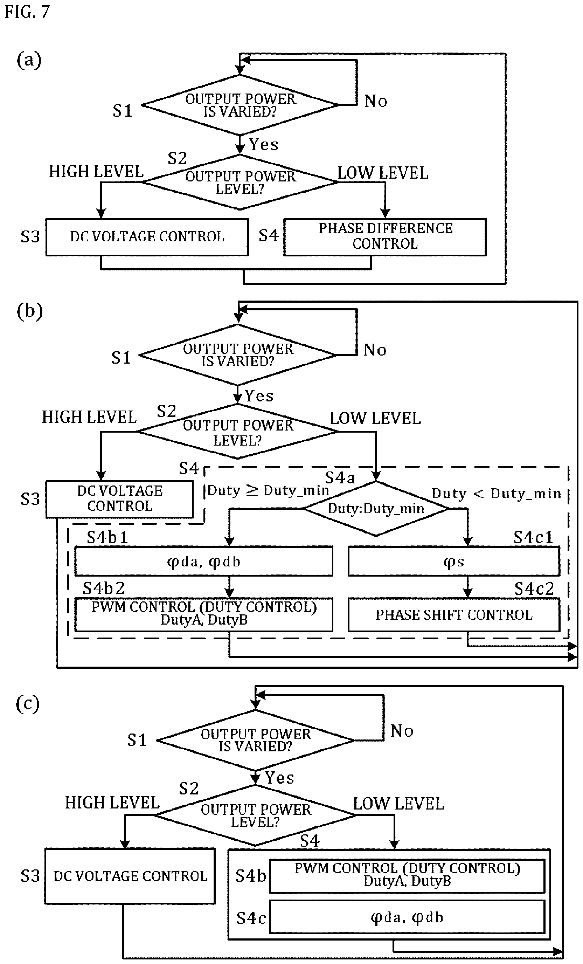

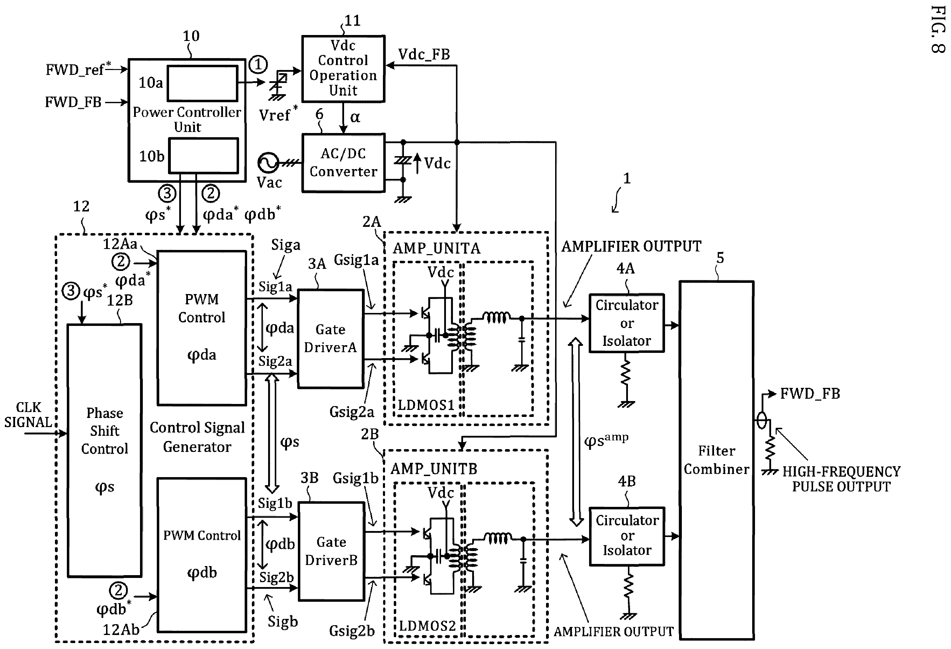

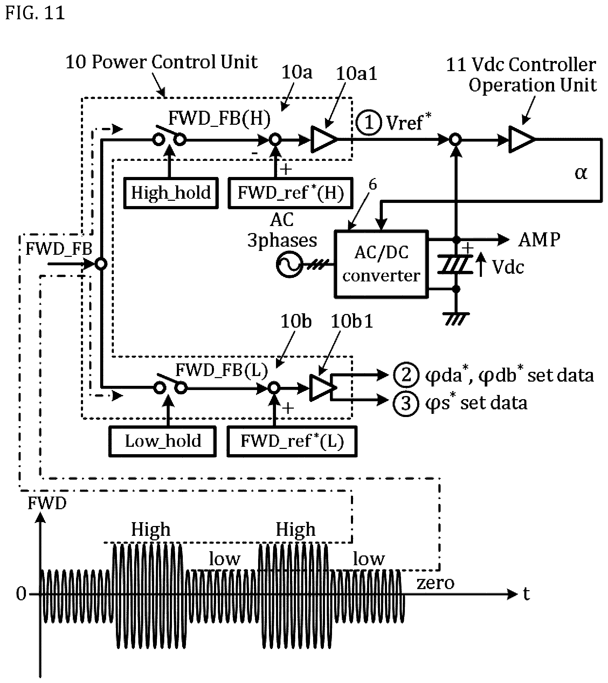

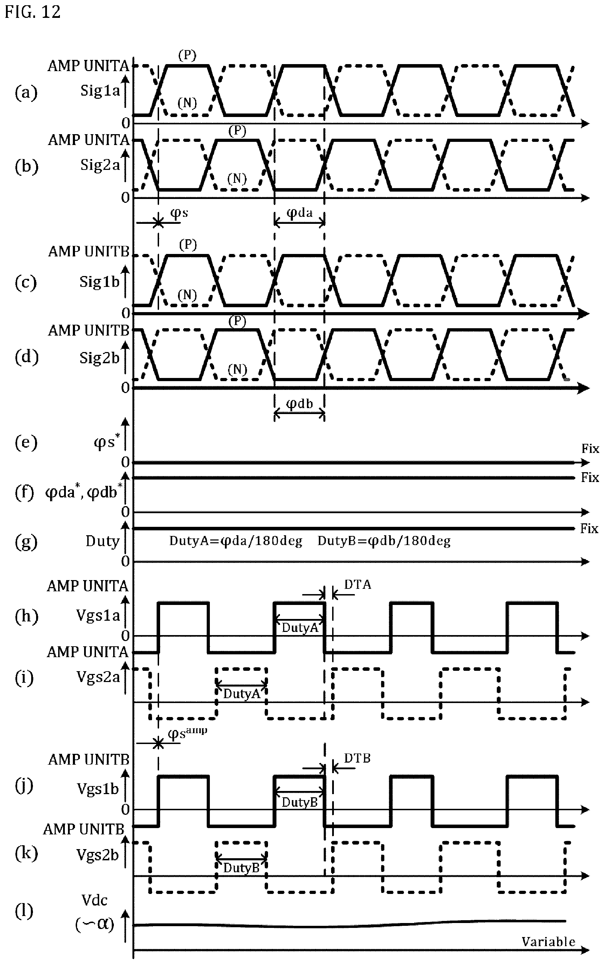

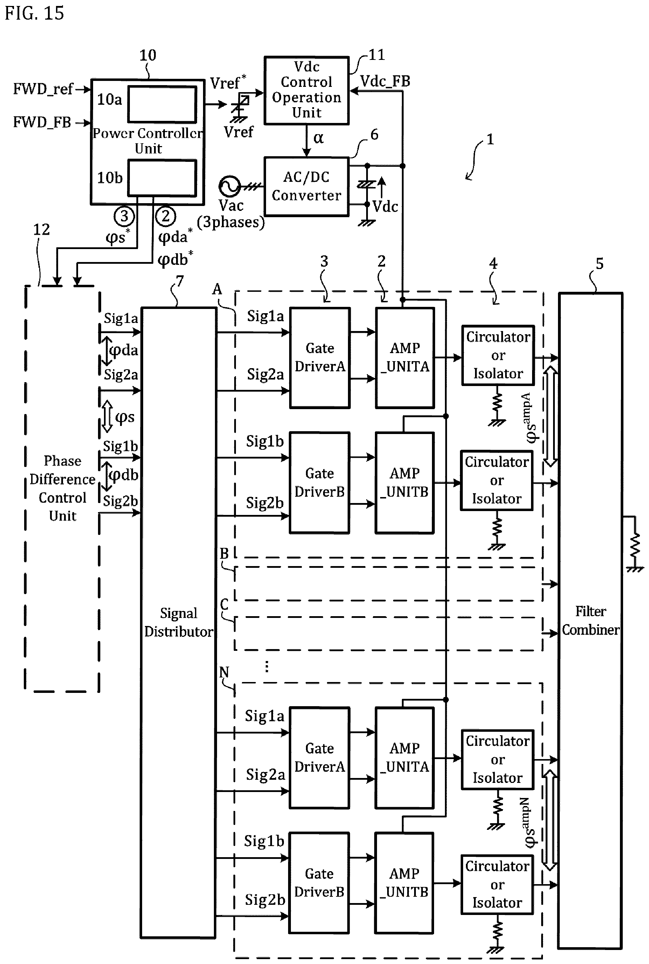

In regard to aspects of the present invention, a description will be made about an output control method for high-frequency power of the invention by referring to a flowchart of FIG. 7, and configuration examples of a high-frequency power supply device of the invention will be made by referring to FIGS. 8 to 10. In addition to that, a description will be made about a configuration example of a main part of a power control unit by referring to FIG. 11. FIGS. 12 to 14 are signal diagrams of, such as, control signals and gate signals in the high-frequency power supply device of the invention. Furthermore, FIG. 15 is referred to describe a configuration example in which multiple sets of the configuration example shown in FIG. 8 are used and connected in parallel in the high-frequency power supply device of the invention.

1. Summary of Control

1-1. Summary of control

A summary of control according to the present invention will be described by referring to FIGS. 1 and 2. FIG. 1 is a schematic diagram illustrating the control according to the invention. FIG. 2 illustrates how to selectively use DC voltage control and phase difference control according to the invention, in which FIG. 2(a) shows a case of controlling a power output by DC voltage control (CNTL1), and FIGS. 2(b) and 2(c) show cases of controlling the power output by phase difference control (CNTL2). Furthermore, FIG. 2(b) shows a case of performing the phase difference control (CNTL2) employing the PWM control, and FIG. 2(c) shows a case of performing the phase difference control (CNTL2) employing phase shift control.

The control of a high-frequency power output according to the present invention selectively uses the DC voltage control (CNTL1) or the phase difference control (CNTL2) according to an output level. The phase difference control (CNTL2) of the present invention is applied for combining amplifier outputs from two amplifiers 2 (2A, 2B) by a combiner 5 to thereby output the output power. The configuration of combining the amplifier outputs from the two amplifiers 2 (2A, 2B) to generate the output power is applied to the power control using the phase shift control that controls an amplifier output phase difference $\phi s^{amp}$ between the amplifier outputs based on a control signal set phase difference $\phi s$ between two sets of control signals input to the amplifiers to thereby control the output power.

The present invention performs the DC voltage control (CNTL1) to control the output power when the output power is controlled in a high-output level range, while performing the phase difference control (CNTL2) to control the output power when the output power is controlled in a low-output level range.

A threshold value for the output level for dividing between the high-output level range and the low-output level range can be defined arbitrary by taking into consideration of a configuration of the DC voltage control and a system of a main circuit, or power conversion efficiency, for instance.

a. DC voltage control (CNTL1)

The control on the output power by the DC voltage control can vary a DC voltage Vdc supplied to an amplifier in the high-output level range.

The DC voltage control fixes a phase difference command value $\phi^*$ to fix a phase difference $\phi$ in the phase difference control, and controls the DC voltage Vdc supplied to a pair of the amplifiers 2 (2A, 2B) based on a DC voltage command value Vref* to control output power, thereby controlling combined output power. The DC voltage command value Vref* is not shown in FIG. 1.

When the power control is performed according to the DC voltage control, the phase difference $\phi$ in the phase difference control is fixed, so as to vary the output power only in the DC voltage control. The phase difference $\phi$ is fixed for fixing phase differences between control signals, which are a control signal phase difference $\phi d$ between the control signals and a control signal set phase difference $\phi s$ between the control signals, and this fixation keeps the output power from being varied due to the control on the phase difference $\phi$.

There is no power consumption by a dummy resistor inside the high-frequency power supply device in the control of the output power by the DC voltage control, so that the problems of the internal loss consumed in a power source and low power conversion efficiency, and thereby high efficiency can be achieved.

Furthermore, even though it is necessary to upsize the device to make the DC voltage control to be compatible in the entire output level range, the size and the weight of the high-frequency power supply device can be reduced by limiting the output level range, in which the DC voltage control of the present invention is applied, to an arbitrary high-output level range.

In FIG. 1, high-output power indicated with a word "High" is output by the DC voltage control, low-output power indicated with a word "Low1" is output by the phase difference control of the PWM control, and low-output power at even lower output level indicated with a word "Low2" is output by the phase difference control of the phase shift control (PS control). Solid arrows, broken arrows and dashed-dotted arrows in FIG. 1 represent the control states by the DC voltage control, the phase difference control of the PWM control and the phase difference control of the phase shift control (PS control), respectively.

FIG. 2(a) shows a control aspect of the power output by the DC voltage control (CNTL1), in which the horizontal axis shows on its left part a control aspect of a control signal, while showing on its right part a control aspect in an amplifier. The vertical axes in FIG. 2 show the output power, and the parts above the broken lines show the high-output level range and the parts below the broken line show the low-output level range.

In the case where the output level range of the output power is the high-output level range, only the DC voltage control is performed in the control aspect of the amplifier to vary the output power. The high-output level range is defined by a maximum value Vdc_max of the DC voltage and a minimum value Vdc_min of the DC voltage. For example, the maximum value Vdc_max of the DC voltage is set according to the specification of a device that generates the DC voltage, such as an AC/DC converter which outputs the DC voltage. The minimum value Vdc_min of the DC voltage is arbitrary determined according to a control system or a main circuit system of a device that generates the DC voltage or according to the power conversion efficiency or the like.

The DC voltage control fixes the control signal phase difference $\phi$d for performing the PWM control of the phase difference control and the control signal set phase difference $\phi$s for performing the phase shift control, so as to control the output power by varying only the DC voltage Vdc without performing the phase difference control for controlling the output power. The fixing value of the phase difference can be set as $\phi$s=0 [deg], and the control signal phase difference $\phi$d can also be set arbitrary. The control signal phase difference $\phi$d and the control signal set phase difference $\phi$s can be fixed by fixing a control signal phase difference command value $\phi$d* and a control signal set phase difference command value $\phi$s*.

b. Phase difference control (CNTL2)

The control signals used for the phase difference control of the present invention may be single-ended signals or signals in differential signaling. However, in the high-frequency power supply device and the output control for high-frequency power that are applied to a high-frequency pulse output that is 1 kw or more with a frequency range being 27 MHz to 100 MHz, the signal in the differential signaling with high noise resistance is suitable for transmitting the phase difference and duty information correctly. In the following, a description will be made about the control signals that are signals in the differential signaling. A signal in the differential signaling includes two signals having phases opposite to each other, and a difference between the two signals enables the conversion of these signals into single-ended signals.

The output power control by the phase difference control (CNTL2) limits the output level range for performing the control to the low-output level range. This can reduce the internal loss due to the dummy resistor in the high-frequency power supply device to thereby achieve the high efficiency.

In FIG. 1, a pair of control signals is input to each of two amplifiers (2A, 2B). A pair of control signals, namely control signals Sig1a and Sig2a, is input to the amplifier 2A and another pair of control signals, namely control signals Sig1b and Sig2b, is input to the amplifier 2B.

Since the control signals Sig1a, Sig2a, Sig1b and Sig2b are the signals in the differential signaling, two pairs of control signals are input to each amplifier, considering two signals in the differential signaling as a pair of signals. In this way, the number of signals contained in the two pairs of control signals is four.

In FIG. 1, a phase difference between the two pairs of control signals input to one amplifier is defined as the control signal phase difference $\phi$d. A phase difference between the two pairs of control signals (Sigla, Sig2a) input to the amplifier 2A is indicated with a control signal phase difference $\phi$da and the two pairs of control signals (Sig1b, Sig2b) input to the amplifier 2B is indicated with a control signal phase difference $\phi$db.

The two pairs of control signals (Sig1a, Sig2a) input to the amplifier 2A and the two pairs of control signals (Sig1b, Sig2b) input to the amplifier 2B form control signal sets, and a phase difference between the control signal sets is indicated with the control signal set phase difference $\phi$s.

The phase difference control (CNTL2) includes two control modes of a first phase difference control (CNTL2d) and a second phase difference control (CNTL2s). The first phase difference control (CNTL2d) is the PWM control for modulating a pulse width based on the control signal phase difference φd, so as to vary a duty ratio (Duty) of a pulse signal that drives a switching element based on the control signals subjected to the PWM control. The second phase difference control (CNTL2s) is the phase shift control (PS control) that shifts the control signal set phase difference φs between a pair of control signal sets, so as to control a degree of an overlap between output power of the two amplifiers.

Since there is no internal loss due to the dummy resistor in the high-frequency power supply device in the control on the output power by the PWM control, the high efficiency can be achieved.

In Figure 1, the control CNTL2d represents the PWM control for modulating the pulse width by the control signal phase difference φd (φda, (φdb) between the two pairs of control signals, and the control CNTL2s represents the phase shift control (PS control) for shifting the control signal set phase difference φs between the pair of control signal sets.

The pulse width control (PWM control) can control the phase difference between the two pairs of the control signal Sig1a and the control signal Sig2a input to the amplifier 2A to be the control signal phase difference φda while controlling the phase difference between the two pairs of the control signal Sig1b and the control signal Sig2b input to the amplifier 2B to be the control signal phase difference φdb.

The control signal Sig1a and the control signal Sig2a consisting of the two pairs of the signals in the differential signaling having the control signal phase difference φda are input to the amplifier 2A, and the duty ratio (Duty) of a gate signal of the switching element is controlled based on the control signal phase difference φda, thereby controlling the output power of the high-frequency pulse output based on the duty ratio (Duty).

Correspondingly, the control signal Sig1b and the control signal Sig2b consisting of the two pairs of the signals in the differential signaling having the control signal phase difference φdb are input to the amplifier 2B, and the duty ratio (Duty) of the gate signal of the switching element is controlled based on the control signal phase difference φdb, thereby controlling the output power of the high-frequency pulse output based on the duty ratio (Duty).

In duty ratio (Duty) control, a duty ratio DutyA by the control signal phase difference φda and a duty ratio DutyB by the control signal phase difference φdb are respectively expressed as below.

$$DutyA = \phi da / 180 \, [deg] \qquad (1)$$

$$DutyB = \phi db / 180 \, [deg] \qquad (2)$$

The phase difference control divides the low-output level range into a high-output level and a low-output level, and employs

(i) a mode applying the PWM control of the first phase difference control to a high-output level, and
(ii) a mode applying the phase shift control (PS control) of the second phase difference control to a low-output level.

(i) Mode applying PWM control

Figure 2(b) shows a mode of controlling the power output only by the PWM control of the first phase difference control in the output power control according to the phase difference control (CNTL2), in which the horizontal axis shows a mode of controlling the control signal on the left side of the dashed-dotted line while showing a mode of the control in the amplifier on the right side. In addition to that, the vertical axis in the figure shows the output power, in which figure the high-output level side is shown above the lower broken line and the low-output level side is shown under this broken line.

When the output level of the output power is on the high-output level side in the low-output level range, the phase difference control of the PWM control (CNTL2d) is performed in the mode of controlling the control signals to vary the output power, and the Duty control is performed in the mode of controlling the amplifier based on the control signal phase difference φd (φda, φdb) between the control signals subjected to the PWM control to thereby vary the output power. A duty ratio Duty (DutyA, DutyB) of a gate signal for driving the amplifier can be obtained based on the control signal phase difference φd (φda, φdb).

The high-output level side in the low-output level range is defined by a maximum duty ratio Duty_max, in which the duty ratio is the largest value, and a minimum duty ratio Duty_min, in which the duty ratio is the smallest value. The maximum duty ratio Duty_max is determined as a minimum necessary dead time DT_min based on a balance between the output power of the switching element and the power conversion efficiency, and a power output obtained by this determination corresponds to a minimum output during the DC voltage control. Furthermore, the minimum duty ratio Duty_min is defined depending on a response speed of the switching element included in the amplifier and is set by a pulse width corresponding to the fastest response speed of the switching element.

The PWM control of the first phase difference control fixes the DC voltage Vdc for performing the DC voltage control and the control signal set phase difference $\phi$s for performing the phase shift control, so as to vary only the control signal phase difference $\phi$d for performing the PWM control to control the output power. The fixed values of the DC voltage Vdc and the control signal set phase difference $\phi$s can be defined arbitrary. The basic value of the control signal set phase difference $\phi$s to be fixed is $\phi$s=0[deg]. The control signal set phase difference $\phi$s=0[deg] can obtain the maximum output in the phase shift control, and thus the control signal set phase difference $\phi$s is fixed to 0[deg] to thereby obtain a control range of the output power in the PWM control that varies the control signal phase difference $\phi$d.

(ii) Mode applying phase shift control (PS control)

FIG. 2(c) shows a mode of controlling the power output performed only by the phase shift control of the second phase difference control in the control of the output power according to the phase difference control (CNTL2). In the figure, the horizontal axis shows a mode of controlling the control signal on the left side of the dashed-dotted line while showing a mode of the control in the amplifier on the right side. In addition to that, the vertical axis in the figure shows the output power, in which figure the high-output level side is shown above the lower broken line and the low-output level side is shown under this broken line.

In a case of lowering the output power than a value controlled by the minimum duty ratio Duty_min in the PWM control, the phase shift control is applied instead of the PWM control. This phase shift control varies the control signal set phase difference $\phi$s between the control signal sets for performing drive control on the amplifier within the range of 0 [deg] to 180 [deg]. The output power having the control signal set phase difference $\phi$s of 0 [deg] in the phase shift control corresponds to output power of which duty ratio Duty is the minimum duty ratio Duty_min in the PWM control. Furthermore, the output power having the control signal set phase difference $\phi$s of 180 [deg] corresponds to zero power in the phase shift control.

In a case where the output level of the output power is on the low power level side within the lower output level, the phase shift control (CNTL2s) of the phase difference control is performed in the control mode of the control signal to vary the output power, and in the control mode for the amplifiers, the switching element is driven by the gate signal with an amplifier phase difference $\phi$s$^{amp}$ based on the control signal set phase difference $\phi$s of the control signal subjected to the phase shift control to vary the output power.

The range of the control signal set phase difference $\phi$s to be subjected to the phase shift control (CNTL2s) is 0 [deg] to 180 [deg]. In the phase shift control (CNTL2s), the maximum output power in the phase shift control can be obtained when the control signal set phase difference $\phi$s is 0 [deg], and the minimum output power in the phase shift control is obtained when the control signal set phase difference $\phi$s is 180 [deg].

The output power when the control signal set phase difference $\phi$s is 0 [deg] is matched to the output power when the duty ratio is the minimum duty ratio Duty_min in the PWM control (CNTL2d) to eliminate the deviation of the output power at the time of changing the mode between the PWM control (CNTL2d) and the phase shift control (CNTL2s), thereby continuously varying the output power.

In the phase difference control, the pulse width controlled by the PWM control defines a pulse width of the gate signal. The pulse width of the gate signal is limited by the operating characteristics of the switching element, so that the minimum pulse width of the pulse width narrowed by the PWM control is also limited that may cause a problem in the PWM control using a pulse width shorter than the minimum pulse width.

The present invention controls the pulse width of the gate signal by the PWM control up to the minimum pulse width of the pulse width narrowed by the PWM control while controlling the pulse width shorter than the minimum pulse width by the phase shift control (PS control), thereby enabling the control even in the low-level range where the control by the PWM control is difficult and thus enabling the control up to an arbitrary low-level range of the output power.

In a case where the minimum output power is large enough to be controlled by the PWM control, the phase difference control is performed only by the PWM control without applying the phase shift control (PS control).

Although the phase shift control (PS control) has the problem of low power conversion efficiency due to the internal loss consumed in the power source, the present invention limits the range of applying the phase shift control (PS control) to the low level, so as to reduce the amount of the internal loss comparing the case of applying the phase shift control (PS control) also on the high-level side. Consequently, the internal loss is reduced over the entire range of the output level, thereby achieving the high efficiency.

The output power can be continuously varied in each output level range in the DC voltage control and the phase difference control according to the present invention, and at the time of changing the control mode from the DC voltage control to the phase difference control or from the phase difference control to the DC voltage control, the output levels achieved by both of the control modes are matched so that the output power at these output levels can be continuously variable over the entire range without being discontinuous.

1-2. Relationship Between Power Control and Output Power

The present invention can arbitrarily set variation characteristics of the output power in each of a high-output voltage range and a low-output voltage range. FIGS. 3 and 4 show examples of the variation characteristics. These figures show examples of four output voltage ranges for a high-output voltage High, low-output voltages Low1 and Low2, and a zero-output voltage.

(a) Aspect of constant output power

Figure 3 shows an example of an aspect that a constant output voltage stabilizes the output power in each output voltage range. In the high-output voltage range, when the constant output power is output at the level High, the DC voltage control is performed on the output power by fixing the control signal phase differences $\phi$da, $\phi$db and the control signal set phase difference $\phi$s while varying the DC voltage Vdc. In this case, the DC voltage Vdc is defined to be a constant voltage to thereby stabilize the output power.

When the constant output power is output at the level Low1, the PWM control is performed on the output power for fixing the DC voltage Vdc and the control signal set phase difference $\phi$s while varying the control signal phase differences $\phi$da, $\phi$db. In this case, the control signal phase differences $\phi$da, $\phi$db are defined to be constant phase differences to stabilize the output power.

When the constant output power is output at the level Low2, the phase shift control is performed on the output power for fixing the DC voltage Vdc and the control signal phase differences $\phi$da, $\phi$db while varying the control signal set phase difference $\phi$s. In this case, the control signal set phase difference $\phi$s is defined to be a constant phase difference to stabilize the output power.

When the zero-output voltage is used, the DC voltage control or the phase difference control is performed to set the output voltage to be the zero-output voltage, and the variation control is not performed on the output voltage.

With the aspect of the constant output power, the output power changes stepwise in each output voltage range.

(b) Aspect of linear variation

Figure 4(a) shows an example of an aspect that the output power is linearly variable in each output voltage range. In the high-output voltage range, when the output power is linearly varied at the level High, the DC voltage control is performed on the output power for fixing the control signal phase differences $\phi$da, $\phi$db and the control signal set phase difference $\phi$s while varying the DC voltage Vdc. In this case, the DC voltage Vdc is varied as root function (square root function) for the linear variation in the output power so that the output power can be varied linearly.

When the output power is linearly varied at the level Low1, the PWM control is performed on the output power for fixing the DC voltage Vdc and the control signal set phase difference $\phi$s while varying the control signal phase differences $\phi$da, $\phi$db. In this case, there is not necessarily a linear relationship between the changes in the control signal phase differences $\phi$da, $\phi$db and the change in the output power, and thus the changes in the control signal phase differences $\phi$da, $\phi$db are adjusted so that the output power is linearly variable.

When the output power is linearly varied at the level Low2, the phase shift control is performed on the output power for fixing the DC voltage Vdc and the control signal phase differences $\phi$da, $\phi$db while varying the control signal set phase difference $\phi$s. In this case, there is not necessarily a linear relationship between the change in the control signal set phase difference $\phi$s and the change in the output power, and thus the control signal set phase difference $\phi$s is adjusted so that the output power is linearly variable.

When the zero-output voltage is used, the DC voltage control or the phase difference control is performed to set the output power to be the zero-output voltage, and the variation control is not performed on the output voltage.

(c) Aspect of exponential variation

Figure 4(b) shows an example of an aspect that the output power is exponentially variable in each output voltage range. In the high-output voltage range, when the output power is exponentially varied at the level High, the DC voltage control is performed on the output power for fixing the control signal phase differences $\phi$da, $\phi$db and the control signal set phase difference $\phi$s while varying the DC voltage Vdc. In this case, the DC voltage Vdc is varied such that the output power is varied exponentially.

When the output power is varied exponentially at the level Low1, the PWM control is performed on the output power for fixing the DC voltage Vdc and the control signal set phase difference $\phi$s while varying the control signal phase differences $\phi$da, $\phi$db. In this case there is not necessarily a linear relationship between the changes in the control signal phase differences $\phi$da, $\phi$db and the change in the output power, and thus the changes in the control signal phase differences $\phi$da, $\phi$db are adjusted so that the output power is exponentially variable.

When the output power is varied exponentially at the level Low2, the phase shift control is performed on the output power for fixing the DC voltage Vdc and the control signal phase differences φda, φdb while varying the control signal set phase difference φs. In this case, there is not necessarily a linear relationship between the change in the control signal set phase difference φs and the change in the output power, and thus the change in the control signal set phase difference φs is adjusted so that the output power is exponentially variable.

When the zero-output voltage is used, the DC voltage control or the phase difference control is performed to set the output power to be the zero-output voltage, and the variation control is not performed on the output voltage.

1-3. Relationship Between Internal Loss and Output Power

Figure 5 shows an output voltage waveform in the PWM control on a push-pull amplifier with switching mode of class D, class F or class EF. An output voltage waveform Vdd represents a drain-to-drain voltage.

The output voltage waveform Vdd is a square waveform, and its amplitude is a drain-to-source voltage Vds. In a switching mode high-frequency power supply, harmonic components other than a fundamental wave are removed by an output filter to thereby output the fundamental wave only. When the output voltage waveform Vdd is equivalently calculated as a sine wave voltage Vac having only the fundamental wave component, it is expressed by the following Equation (3). In here, a duty ratio Duty is normalized by 180 [deg] in a half period.

$$Vac = (4/\pi) \cdot Vds \cdot \sin\{(\pi/2) \cdot Duty\} \cdot \sin(\omega_s \cdot t) \qquad (3)$$

Vac: sine wave voltage
Vds: drain-to-source voltage
Duty: duty ratio
cos: angular frequency of fundamental wave

Figure 6 shows that output power $P_{out}$ is calculated based on Equation (3) when the PWM control is performed to vary the duty ratio Duty in the high-frequency power supply. In FIG. 6, the horizontal axis indicates the duty ratio Duty[%] and the vertical axis indicates the power $P_{out}$. In the switching mode, a dead time DT is provided to the gate signal voltage Vgs to achieve the high efficiency.

The voltage Vac shown in Equation (3) is a function that draws an S-shaped curve because the term of the duty ratio Dury exists in the sine function. In this S-shaped curve, the voltage Vac shows approximately linear characteristic with the duty ratio Duty of 20 % to 80 %, whereas the slope is gentle in the range where the duty ratio Duty is 80 % or more and the range where the duty ratio Duty is 20 % or less, and thus non-linear characteristic strongly appears. Due to these output characteristics of the sine wave voltage Vac, Duty versus output power gain varies extremely low except in the range where the duty ratio Duty is 20 % to 80 % in the PWM control for the high-frequency power supply, thereby causing the difficulty in adjusting the output power gain by the duty ratio Duty, resulting in poor controllability.

In accordance with the above-described output power characteristics, a rated duty in the PWM control is selected to be close to 80 % to avoid the range of the duty ratio Duty that causes the poor controllability. The duty ratio Duty near 80 % is equivalent to 140 [deg] to 160 [deg] in terms of the control signal phase differences φda, φdb.

On the other hand, when the duty ratio Duty_min, at which the pulse width is at the minimum, is selected to be 20 %, the output power is 1/10 of rated power. When the range of the duty ratio Duty is selected to be within 20 % to 80 % and a control domain that is defined by this duty ratio Duty is a PWM control domain, the output power at the minimum duty ratio Duty-min is reduced to 10 % of the rated output. FIG. 6 indicates the ranges of the output power in the PWM control domain with P_high and P_low.

In a case of reducing the output power to be lower than a value controlled by the minimum duty ratio Duty_min, the phase shift control is applied instead of the PWM control. The phase shift control varies the control signal set phase difference φs which is a phase difference between the amplifiers within the range of 0 [deg] to 180 [deg]. In the phase shift control, the output power with the control signal set phase difference φs of 0 [deg] corresponds to the output power with the minimum duty ratio Duty_min. Furthermore, the output power with the control signal set phase difference φs of 180 [deg] corresponds to zero power in the phase shift control.

The maximum internal loss of the phase shift control becomes maximum when the control signal set phase difference φs is 180 [deg], but in the present invention, the internal loss at this time is equal to the output power when the duty ratio Duty is the minimum duty ratio Duty_min. In a case where the phase shift control is performed on the output power in all control ranges, power equal to the rated power on the High side is consumed in an internal dummy resistor when the output power is reduced to zero (φs=180 [deg]). However, according to the present invention, since the control signal set phase difference φs of 180 [deg] corresponds to the output power when the duty ratio Duty is the minimum duty ratio Duty_min, the internal loss can be about 1/10.

Since the internal loss can be about 10 % of the rated power, the internal loss is improved by approximately 90 % comparing the case of the output power control performed only by the phase shift control.

2. Output Control Method for High-Frequency Power

An output control method for high-frequency power according to the present invention will be described by referring to a flowchart of FIG. 7. The flowchart described below shows process flow by using reference letter S.

The outline of the output control for the high-frequency power according to the present invention is that the DC voltage control and the phase difference control are selectively applied depending on the output power level to thereby reduce the internal loss caused by the dummy resistor in the high-frequency power supply.

Figure 7(a) is a flowchart illustrating the outline of the output control. When the output power is varied (S1), a determination is made whether the level of the output power is in a preset high-level range (high-output level range) or in a low-level range (low-output level range) (S2). When the output power level is in the high-level range, the DC voltage control is performed (S3), and when the output power level is in the low-level range, the phase difference control is performed (S4).

Figure 7(b) is a flowchart showing a detailed flow of the phase difference control, and shows the process of the step S4 in the flowchart shown in FIG. 7(a) in a box drawn by a broken line. When it is determined that the output power level is within the low-level range (S2), the duty ratio Duty of drive signals for driving the switching elements of the amplifiers are compared with the minimum duty ratio Duty_min which is set beforehand (S4a).

In the comparison process in the step S4a, when the duty ratio Duty is larger than the minimum duty ratio Duty_min, the phase difference operation of the phase difference control is performed to obtain control signal phase difference command values $\phi da*$ and $\phi db*$, so as to generate control signals having the control signal phase differences $\phi da$, $\phi db$ based on the obtained control signal phase difference control values $\phi da*$, $\phi db*$ (S4b1). Then, duty ratios DutyA, DutyB for the drive signals are obtained based on the generated control signal phase differences $\phi da$, $\phi db$, and the obtained duty ratios DutyA, DutyB are used to perform the PWM control on the switching elements of the amplifiers (S4b2).

On the other hand, when the duty ratio Duty is smaller than the minimum duty ratio Duty_min in the comparison process in the step S4a, the phase difference operation of the phase difference control is performed to obtain control signal set command value phase difference $\phi s*$. Then, control signals having the control signal set phase differences $\phi s$ are generated based on the obtained control signal set phase difference command value $\phi s*$ (S4c1), so as to perform the phase shift control on the switching elements of the amplifier (S4c2).

In the process of the step S4a, when the duty ratio Duty matches the minimum duty ratio Duty_min, it is possible to arbitrarily define whether the PWM control is performed by using the control signal phase differences obtained in the step S4b or the phase shift control is performed by using the control signal set phase difference obtained in the step S4c.

In the flowchart shown in Figure 7(b), either the PWM control or the phase shift control is selected in the phase difference control, but the PWM control and the phase shift control can be implemented simultaneously as shown in the flowchart in FIG. 7(c).

In the phase difference control (S4), the control signal phase difference command values $\phi da*$, $\phi db*$ and the control signal set phase difference command value $\phi s*$ are obtained by calculation, and based on the obtained command values $\phi da*$, $\phi db*$ and $\phi s*$ pertaining to the phase difference, control signals having the phase differences $\phi da$, $\phi db$ and $\phi s$ are generated to perform the PWM control (S4b) as well as the phase shift control (PS control) (S4c).

In a case of performing the PWM control (S4b) and the phase shift control (S4c) simultaneously in the phase difference control (S4), the internal loss increases comparing the case where the PWM control and the phase shift control are performed separately. For example, when the duty ratio Duty is 50 % and the control signal set phase difference $\phi s$ is 90 [deg], 25 % of the rated output become the internal loss. However, this internal loss is reduced to 1/4 of the loss caused in the output power control performed only by the phase shift control, so that it has superiority over conventional methods.

3. High-Frequency Power Supply Device

Configuration examples of the high-frequency power supply device of the present invention will be described by referring to FIGS. 8 to 10.

3-1. Configuration Example 1

Configuration Example 1 will be described based on FIG. 8. A high-frequency power supply device 1 includes a pair of amplifiers 2A and 2B, and a combiner 5 that combines amplifier outputs from the amplifiers 2A and 2B to generate a high-frequency pulse output.

The amplifiers 2A, 2B are power amplifiers by a class-D, class-F or class-EF switching mode, each of them including an AD/DC converter as a constitutional element for constituting a DC power source for supplying a DC voltage Vdc to the power simplifier. FIG. 8 shows an example in which switching elements consisting of two LDMOS devices or formed in one package, an output transformer and a low-pass filter are connected in series. To a midpoint of the output transformer, the DC voltage Vdc is applied from the DC power source of an AC/DC converter 6.

Each of the amplifiers 2A, 2B includes two switching elements having gate terminals, and gate signals Gsig1a, Gsig2a and gate signals Gsig1b, Gsig2b are input as drive signals to the gate terminals from drive circuits 3A and 3B, so as to drive each switching element is driven with the gate signal.

The amplifier outputs from the amplifiers 2A, 2B are input to the combiner 5 through circulators/isolators 4A, 4B. The combiner 5 combines the amplifier outputs from the amplifiers 2A, 2B to output a resultant output as a high-frequency pulse output. The circulators/isolators 4A, 4B are connected with dummy resistors. Among the amplifier outputs, the outputs that are not combined by the combiner 5 are consumed in the dummy resistors and thus become an internal loss.

The high-frequency power supply device 1 is configured to perform the DC voltage control and the phase difference control as the configurations for controlling the output power of the amplifiers 2A, 2B. The DC voltage control is implemented by a power control unit 10 and a DC voltage control unit 11, and the phase difference control is implemented by the power control unit 10 and a control signal generation unit 12.

(Power Control Unit)

The power control unit 10 is configured to compute a command value for controlling the output power, and the control signal generation unit 12 is configured to generate control signals to be used for the phase control difference control based on the phase difference command value computed by the power control unit 10.

The power control unit 10 changes the control mode between the DC voltage control and the phase difference control according to an output level of the high-frequency pulse output from the high-frequency power supply device 1, then computes a DC voltage command value Vref* by the DC voltage control when the output level is in a high-output level range while computing a phase difference command value $\phi^*$ ($\phi d^*$, $\phi s^*$) when the output level is in a low-output level range, and sends the DC voltage command value Vref* to the DC voltage control unit 11 while sending the phase difference command value $\phi^*$ ($\phi d^*$, $\phi s^*$) to the control signal generation unit 12.

The DC voltage command value Vref* and the phase difference command value $\phi^*$ ($\phi d^*$, $\phi s^*$) can be obtained by the computation based on a difference between an output power command value FWD_ref* and an output power feedback value FWD_FB.

The power control unit 10 includes a DC voltage computation unit 10a that computes the DC voltage command value Vref* for controlling the output power by the DC voltage control, and a phase difference computation unit 10b that computes the phase difference value $\phi^*$ ($\phi d^*$, $\phi s^*$) for controlling the output power by the phase difference control.

(DC Voltage Computation Unit)

The DC voltage computation unit 10a is configured to compute the DC voltage command value Vref* for matching the output power to the output power command value FWD_ref* based on a difference between the output power command value FWD_ref* and the output power feedback value FWD_FB.

The DC voltage command value Vref* can be computed by performing feedback control that makes the difference between the output power command value FWD_ref* and the output power feedback value FWD_FB to be zero. For example, when a difference (FWD_ref*)-(FWD_FB) is a positive value, the output power feedback value FWD_FB is smaller than the output power command value FWD_ref*, so that the value Vref* which is the output power command value, is increased to bring the output power feedback value FWD_FB close to the output power command value FWD_ref*. On the other hand, when the difference (FWD_ref*)-(FWD_FB) is a negative value, the output power feedback value FWD_FB is larger than the output power command value FWD_ref*, so that the value Vref* which is the output power command value, is decreased to bring the output power feedback value FWD_FB close to the output power command value FWD_ref*.

The DC voltage command value Vref* is used for calculating a manipulated variable $\alpha$ for controlling the DC voltage Vdc to be supplied to the pair of amplifiers 2A and 2B in the DC voltage control unit 11.

(Phase Difference Computation Unit 10b)

The phase difference computation unit 10b computes a phase difference command value $\phi^*$ to be used for performing the phase difference control on the output power based on the difference between the output power command value FWD_ref* and the output power feedback value FWD_FB. The phase difference command value $\phi^*$ includes the

control signal phase difference command values φda*, φdb* for the PWM control and the control signal set phase difference command value φs*, and the control signal generation unit 12 generates control signals having a phase difference φ (φda, φdb, φs) based on the phase difference command value φ* φda*, φdb*, φs*).

(DC Voltage Control Unit and Control Signal Generation Unit)

The high-frequency power supply device 1 includes the DC voltage control unit 11 that control the output power, and the control signal generation unit 12 that generates control signals in the form of the signals in the differential signaling having the phase difference φ (φd, φs) input to the pair of the amplifiers 2A, 2B based on the phase difference command value φ* (φd*, φs*) computed by the power control unit 10, so as to control the output power.

The DC voltage command value Vref* used for the DC voltage control as well as the control signal phase differences φda, φdb and the control signal set phase difference φs used for the phase difference control can be obtained by the computation by the power control unit 10.

(DC Voltage Control Unit)

The DC voltage control unit 11 is provided to perform the DC voltage control. The DC voltage control unit 11 generates the manipulated variable α based on the DC voltage command value Vref . The AC/DC converter 6 constituting the DC power source is controlled based on the manipulated variable α so that the output voltage of the DC voltage Vdc according to the DC voltage command value Vref* is supplied to the amplifiers 2A, 2B.

The DC voltage control unit 11 compares feedback voltages Vdc_FB that are returned from the amplifiers 2A, 2B with the DC voltage command value Vref* to thereby perform the feedback control to match the DC voltage Vdc with the DC voltage command value Vref*.

(Control Signal Generation Unit)

The control signal generation unit 12 is provided to perform the phase difference control. The control signal generation unit 12 includes phase difference control function units 12Aa and 12Ab that perform the PWM control and a phase difference control function unit 12B that perform the phase shift control.

The control signal phase differences φda, φdb of the phase difference control function units 12Aa, 12Ab for the PWM control and the control signal set phase difference φs of the phase difference control function unit 12B for the phase shift control are generated based on the phase command value obtained by the computation processing by the power control unit 10.

(PWM Control)

The phase difference control function units 12Aa, 12Ab performing the PWM control generate control signals Sig1a, Sig2a for controlling the amplifier 2A and control signals Sig1b, Sig2b for controlling the amplifier 2B, respectively. In a case where the control signals Sig1a, Sig2a, Sig1b and Sig2b are formed from a signal in the differential signaling, signals of which are in a reverse-phase relation to each other, two pairs of control signals including a pair of signals in the differential signaling are input to each amplifier. Consequently, the control signals Sig1a, Sig2a input to the amplifier 2A form a set signal Siga, which consists of the two pairs of the control signals including the pair of the signals in the differential signaling, and the control signals Sig1b, Sig2b input to the amplifier 2B also form a set signal Sigb, which consists of the two pairs of the control signals including the pair of the signals in the differential signaling. In this way, the numbers of signals contained in the set signal Siga and the set signal Sigb are four.

In regard to the control signals Sig1a, Sig2a that form the set signal Siga to be input to the amplifier 2A, the control signal phase difference φda between the control signal Sig1a and the control signal Sig2a is created based on the control signal phase difference command value φda*, and based on the created control signal phase difference φda, the PWM control is performed on the pulse widths of the gate signals Gsig1a, Gsig2a output from the drive circuit 3A.

Correspondingly, in regard to the control signals Sig1b, Sig2b that form the set signal Sigb to be input to the amplifier 2B, the control signal phase difference φdb between the control signal Sig1b and the control signal Sig2b is created based on the control signal phase difference command value φdb*, and based on the created control signal phase difference φdb, the PWM control is performed on the pulse widths of gate signals Gsig1b, Gsig2b output from the drive circuit 3B.

The PWM control is performed to allow the drive circuit 3A to output an amplifier output that corresponds to the control signal phase difference φda and the drive circuit 3B to output an amplifier output that corresponds to the control signal phase difference φdb. In a case where the amplifiers 2A, 2B output amplifier outputs corresponding to the control signal phase difference φd, the PWM control is performed with the control signal phase difference φda and the control signal phase difference $\phi$db being the same phase difference.

The control signal phase difference command value $\phi$d* can be computed by performing the feedback control to make the difference between the output power command value FWD_ref* and the output power feedback value FWD_FB to be zero.

For example, when a difference (FWD_ref*)-(FWD_FB) is a positive value, the output power feedback value FWD_FB is smaller than the output power command value FWD_ref*, so that the control signal phase difference command value $\phi$d* is increased to bring the duty ratio Duty, which expands the pulse width, close to the maximum duty ratio Duty_max, thereby bringing the output power feedback value FWD_FB close to the output power command value FWD_ref*.

On the other hand, when the difference (FWD_ref*)-(FWD_FB) is a negative value, the output power feedback value FWD_FB is larger than the output power command value FWD_ref*, so that the control signal phase difference command value $\phi$d* is decreased to bring the duty ratio Duty, which narrows the pulse width, close to the minimum duty ratio Duty_min, thereby bringing the output power feedback value FWD_FB close to the output power command value FWD_ref*.

(Phase Shift Control)

The phase difference control function unit 12B for performing the phase shift control provides the control signal set phase difference $\phi$s between the set signal Siga consisting of the control signals Sig1a, Sig2a and the set signal Sigb consisting of the control signals Sig1b, Sig2b, the control signals being for controlling the amplifiers 2A, 2B, respectively.

The control signal set phase difference $\phi$s provides the phase difference $\phi$s between the signal set of the gate signals Gsig1a, Gsig2a output from the drive circuit 3A and the signal set of the set signal of the gate signals Gsig1b, Gsig2b output from the drive circuit 3B, so as to use the phase difference $\phi$s for the phase shift control to control an overlap between the phases for outputting the amplifier output of the drive circuit 3A and the amplifier output of the drive circuit 3B simultaneously. The phase shift control is performed on an amplifier output phase difference $\phi$s$^{amp}$ between the amplifier output of the drive circuit 3A and the amplifier output of the drive circuit 3B based on the control signal set phase difference $\phi$s between the control signals generated by the control signal set phase difference command value $\phi$s*.

The control signal set phase difference command value $\phi$s* is computed by performing the feedback control for making the difference between the output power command value FWD_ref* and the output power feedback value FWD_FB to be zero.

For example, when the difference (FWD_ref*)-(FWD_FB) is a positive value, the output power feedback value FWD_FB is smaller than the output power command value FWD_ref*, so that the control signal set phase difference command value $\phi$s* is brought close to zero [deg] to thereby bring the output power feedback value FWD_FB close to the output power command value FWD_ref*.

On the other hand, when the difference (FWD_ref*)-(FWD_FB) is a negative value, the output power feedback value FWD_FB is larger than the output power command value FWD_ref*, so that the control signal set phase difference $\phi$s is brought close to 180 [deg] to thereby bring the output power feedback value FWD_FB close to the output power command value FWD_ref*.

The phase difference control function units 12Aa, 12Ab for the PWM control and the phase difference control function unit 12B for the phase shift control generate the control signals Sig1a, Sig2a and the control signals Sig1b, Sig2b as the signals in the differential signaling based on clock signals (CLK signals), based on the control signal phase difference command values $\phi$da*, $\phi$db* and the control signal set phase difference command value $\phi$s* obtained by the computation processing by the power control unit 10.

The functional part of the phase difference control function units 12Aa, 12Ab for the PWM control and the phase difference control function unit 12B for the phase shift control can be formed, for instance, by a signal oscillator that varies a frequency/phase of a direct digital synthesis (DDS) or an integrated circuit of a filed programmable gate way (FPGA).

Figure 8 indicates the DC voltage command value Vref* with encircled number 1, the control signal phase difference command value $\phi$d* ($\phi$da*, $\phi$db*) with encircled number 2, and the control signal set phase difference command value $\phi$s* with encircled number 3.

3-2. Configuration Example 2

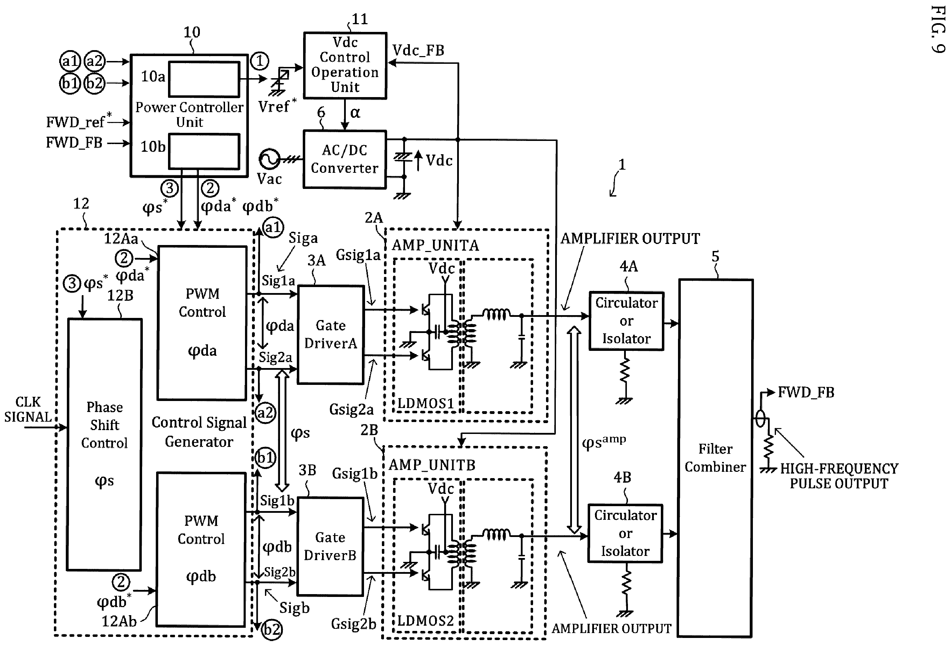

Configuration Example 2 will be described based on FIG. 9. In Configuration Example 2, a determination is made about whether or not the control signal phase difference $\phi$d created by the control signal generation unit 12 matches the control signal phase difference command value $\phi$d* computed by the power control unit 10, and when the control signal phase difference $\phi$d created by the control signal generation unit 12 does not match the control signal phase difference command value $\phi$d*, the control signal phase difference $\phi$d is adjusted to match the control signal phase difference command value φd*.

In the adjustment of the control signal phase difference φd, the adjustment of the control signal phase difference φda between the control signals Sigla, Sig2a is performed separately from the adjustment of the control signal phase difference φdb between the control signals Sig1b, Sig2b.

In Figure 9, encircled numbers a1 and a2 show paths in which the control signals Sigla, Sig2a output from the control signal generation unit 12 are fed back to the power control unit 10 to determine the control signal phase difference φda between the control signal Sig1a and the control signal Sig2a, and encircled numbers b1 and b2 show paths in which the control signals Sig1b, Sig2b output from the control signal generation unit 12 are fed back to the power control unit 10 to determine the control signal phase difference φdb between the control signal Sig1b and the control signal Sig2b.

The phase difference computation unit 10b compares the control signal phase difference command value φda* obtained by the computation with the control signal phase difference φda obtained by the feedback, so as to adjust the command value for giving a command to the control signal generation unit 12 to match the control signal phase difference φda to the control signal phase difference command value φda*. Correspondingly, the phase difference computation unit 10b compares the control signal phase difference command value φdb* obtained by the computation with the control signal phase difference φdb obtained by the feedback, so as to adjust the command value for giving a command to the control signal generation unit 12 to match the control signal phase difference φdb to the control signal phase difference command value φdb*. The control signal generation unit 12 adjusts the control signal phase differences φda, φdb based on the adjusted command values.

3-3. Configuration Example 3

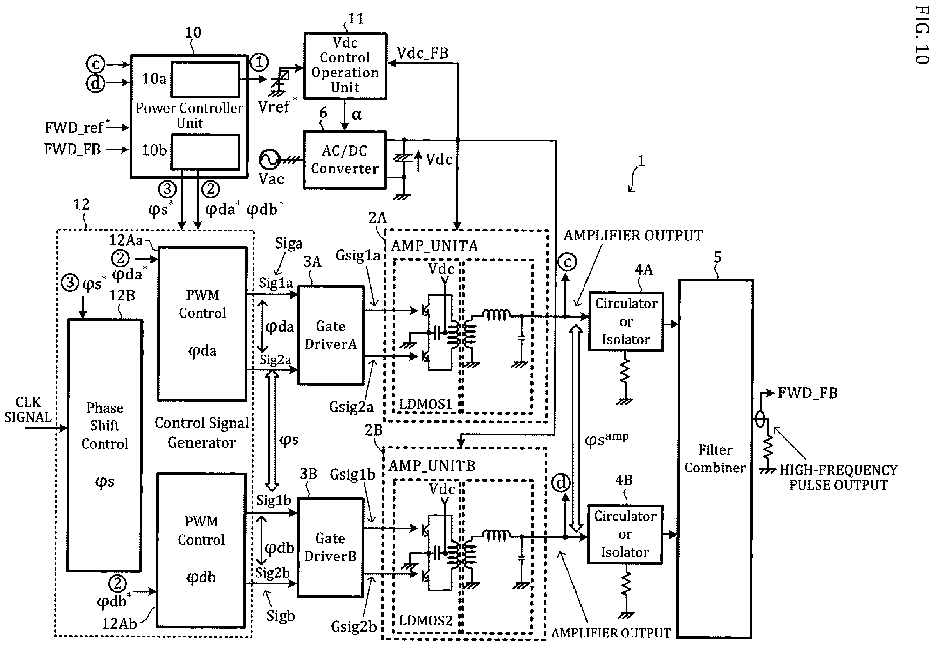

Configuration Example 3 will be described based on FIG. 10. In Configuration Example 3, a determination is made about whether there is a difference between the amplifier outputs generated by the amplifiers 2A and 2B, and when there is a mismatch between the amplifier outputs, the control signal set phase difference φs created by the control signal generation unit 12 is adjusted. In FIG. 10, encircled letters c and d indicate paths in which the amplifier outputs of the amplifier 2A and the amplifier 2B are fed back to the power control unit 10 to obtain the control signal set phase difference φs.

The phase difference computation unit 10b compares the control signal set phase difference command value φs* obtained by the computation with the control signal set phase difference φs obtained by the feedback, so as to adjust the command value for giving a command to the control signal generation unit 12 to match the control signal set phase difference φs to the control signal set phase difference command value φs*. The control signal generation unit 12 adjusts the control signal set phase difference φs based on the adjusted command values.

3-4. Configuration Example of Main Part of Power Control Unit

Figure 11 shows a configuration example of the main part of the power control unit. The figure shows an example in which the output power feedback value FWD_FB has two output levels of a High-output and a Low-output.

When the output power feedback value FWD_FB is at the High-output level, a High_hold signal is used to sample (keep) the High-output to determine a difference between the sampled High-output and an output power command value FWD_ref*(H) on the High-side, and the difference is power amplified by a power controller 10a1 to compute the DC voltage command value Vref . The DC voltage command value Vref* is converted into the manipulated variable α by the power controller 10a1 to thereby control the AC/DC converter of the DC power source 6. The DC power source 6 performs AC-DC conversion to convert an alternate current in an AC source into a direct current, so as to output the DC voltage Vdc.

When the output power feedback value FWD_FB is at the Low-output level, a Low_hold signal is used to sample (keep) the Low-output to determine a difference between the sampled Low-output and an output power command value FWD_ref*(L) on the Low-side, and the difference is power amplified by a power controller 10b1 and then each phase difference data is computed for the control signal phase difference command value φd* and the control signal set phase difference command value φs*.

3-5. Schematic Signal Example

3-5a. Signal example at high-output level (DC voltage control)

Figure 12 schematically shows a signal in each unit of the high-frequency power supply device of the present invention, which is a schematic signal example in performing the DC voltage control in the high-output level range.

When the DC voltage control is performed, the control signal phase difference command value φd* and the control signal set phase difference command value φs* are fixed, and the DC voltage control using the DC voltage Vdc is performed to vary the output power.

Figures 12(a) and 12(b) show control signals Sig1a, Sig2a on the side of an amplifier (AMP_UNITA), and FIGS. 12(c) and 12(d) show control signals Sig1b, Sig2b on the side of an amplifier (AMP_UNITB). The signals are examples of signals in the differential signaling indicated by reference letters P and N that are opposite to each other in their phases. FIGS. 12(a), 12(b), 12(c) and 12(d) show the signal P with a solid line and the signal N with a broken line.

Figure 12(e) shows a control signal set phase difference command value $\phi s^*$ between a set signal of the control signal Sigia and the control signal Sig2a and a set signal of the control signal Sig1b and the control signal Sig2b, and the control signal set phase difference command value $\phi s^*$ is fixed. The control signal set phase difference command value $\phi s^*$ can be a fixed value of zero [deg], for instance, but may be a phase difference other than zero [deg].

Figure 12(f) shows that the control signal phase difference command value $\phi da^*$ of the control signal Sigia and the control signal Sig2a and the control signal phase difference $\phi db^*$ of the control signal Sig1b and the control signal Sig2b are fixed. Since the control signal phase difference command values $\phi da^*$, $\phi db^*$ are fixed, duty ratios Duty for gate signals for driving the amplifiers are also fixed (FIG. 12(g)).

The fixed values of the control signal phase difference command values $\phi da^*$, $\phi db^*$ are recommended to be 140 [deg] to 160 [deg] considering high efficiency, and the duty ratio Duty based on the control signal phase difference $\phi d$ is set as the rated duty.

Figures 12(h) and 12(i) show gate signal voltages Vgs1a, Vgs2a on the amplifier (AMP_UNITA) side, and FIGS. 12(j) and 12(k) show gate signal voltages Vgs1b, Vgs2b on the amplifier (AMP_UNITB) side. The pulse width of each voltage is defined by a duty ratio DutyA or duty ratio DutyB shown in FIG. 12(g). Reference letter DTA represents a dead time between the gate signal voltage Vgsia and the gate signal voltage Vgs2a, and reference letter DTB represents a dead time between the gate signa voltage Vgs1b and the gate signal voltage Vgs2b. FIG. 12(l) shows a DC voltage Vdc that is defined by a manipulated variable $\alpha$ by the DC voltage control.

The phase difference between the gate signal voltage Vgsia and the gate signal voltage Vgs1b is an amplifier output phase difference $\phi s^{amp}$ between the amplifier 2A and the amplifier 2B, and corresponds to the control signal set phase difference $\phi s$. When the control signal set phase difference command value $\phi s^*$ is fixed to the fixed value of zero [deg], the amplifier output phase difference $\phi s^{amp}$ is zero [deg].

3-5b. Signal example at low-output level (PWM control)

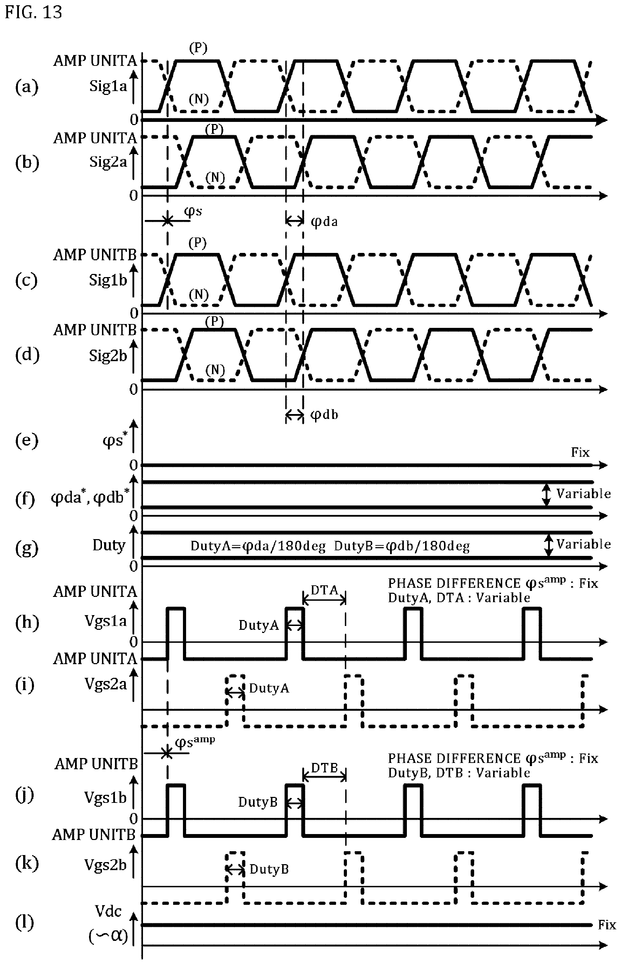

Figure 13 schematically shows a signal of each unit of the high-frequency power supply device of the present invention, which is a schematic signal example of performing the phase difference control by the PWM control in the low-output level range.

When the PWM control is performed, a DC voltage command value Vdc* and the control signal set phase difference command value $\phi s^*$ are fixed, and the variable control is performed on the output power by the phase shift control to vary the control signal phase difference $\phi d$.

Figures 13(a) and 13(b) show control signals Sigia, Sig2a on the amplifier (AMP_UNITA) side, and FIGS. 13(c) and 13(d) show control signals Sig1b, Sig2b on the amplifier (AMP_UNITB) side. The signals are examples of signals in the differential signaling indicated by reference letters P and N that are opposite to each other in their phases. FIGS. 13(a), 13(b), 13(c) and 13(d) show the signal P with a solid line and the signal N with a broken line.

Figure 13(e) shows a control signal set phase difference command value $\phi s^*$ between a set signal of the control signal Sigia and the control signal Sig2a and a set signal of the control signal Sig1b and the control signal Sig2b, and the control signal set phase difference command value $\phi s^*$ is fixed.

Figure 13(f) shows that the control signal phase difference $\phi da$ between the control signal Sigia and the control signal Sig2a and the control signal phase difference command value $\phi db^*$ of the control signal Sig1b and the control signal Sig2b are variable. Since the control signal phase difference command values $\phi da^*$, $\phi db^*$ are variable, duty ratios Duty for gate signals for driving the amplifiers are also variable (FIG. 13(g)).

Figures 13(h) and 13(i) show gate signal voltages Vgs1a, Vgs2a on the amplifier (AMP_UNITA) side, and FIGS. 13(j) and 13(k) show gate signal voltages Vgs1b, Vgs2b on the amplifier (AMP_UNITB) side. The pulse width of each voltage is variable by a duty ratio DutyA or duty ratio DutyB. Reference letter DTA represents a dead time between the gate signal voltage Vgsia and the gate signal voltage Vgs2a, and reference letter DTB represents a dead time between the gate signal voltage Vgs1b and the gate signal voltage Vgs2b, these dead times being varied with variations in the duty ratios DutyA and DutyB. The duty ratios DutyA and DutyB are variable so as to lower the output power than output power at the rated duty set at the high-output level.

Figure 13(l) shows a DC voltage Vdc that is defined by a manipulated variable $\alpha$ by the DC voltage control, and the DC voltage Vdc is fixed because the DC voltage control is not performed on it.

The phase difference between the gate signal voltage Vgsia and the gate signal voltage Vgs1b is an amplifier output phase difference $\phi s^{amp}$ between the amplifier 2A and the amplifier 2B, and corresponds to the control signal set phase difference $\phi s$. When the control signal set phase difference command value $\phi s^*$ is fixed to the fixed value of zero [deg], the amplifier output phase difference $\phi s^{amp}$ is zero [deg].

In a case where the control signal phase difference $\phi d$ is varied within the range from the rated duty set at the high-output level to a minimum duty ratio Duty_min and the output power is caused to droop further to the low-output side beyond the minimum duty ratio Duty_min, the phase shift control is applied for the PWM control.

3-5c. Signal example at low-output level (phase shift control)

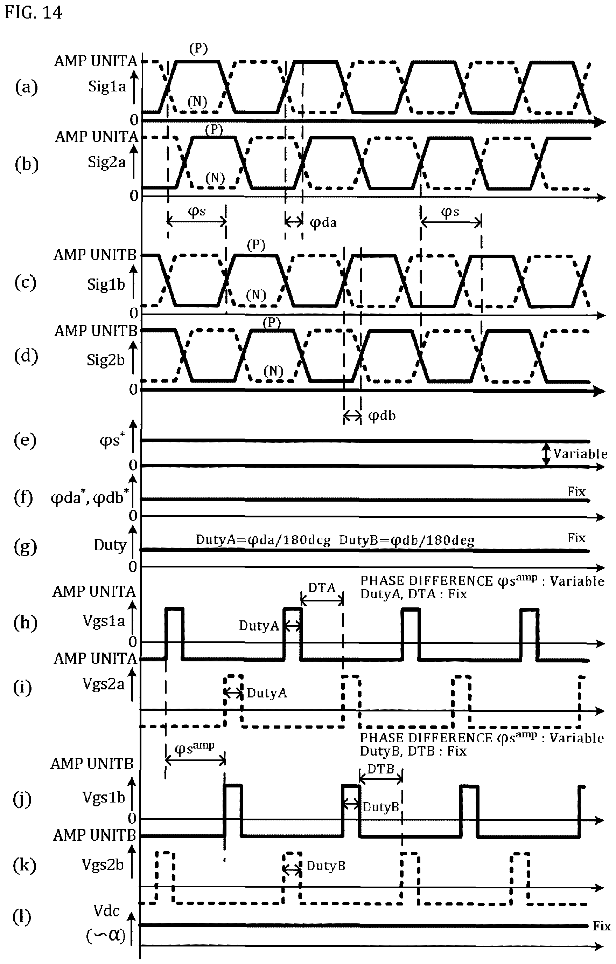

Figure 14 schematically shows a signal in each unit of the high-frequency power supply device of the present invention, which is a schematic signal example of performing the phase difference control by the phase shift control in the low-output level range.

The phase shift control is applied in a case where the output power cannot be reduced even when the pulse width is narrowed to the minimum duty ratio Duty_min by the PWM control. When the phase shift control is performed, the DC voltage command value Vdc* and the control signal phase difference command value $\phi d^*$ are fixed, and the phase shift control for varying the control signal set phase difference $\phi s$ is performed to vary the output power. The control signal set phase difference $\phi s$ is made to be variable in a range of 0 [deg] $\leq \phi s \leq$ 180 [deg] to thereby droop the output power to zero.

Figures 14(a) and 14(b) show control signals Sigia, Sig2a on the amplifier (AMP_UNITA) side, and FIGS. 14(c) and 14(d) show control signals Sig1b, Sig2b on the amplifier (AMP_UNITB) side. The signals are examples of signals in the differential signaling indicated by reference letters P and N that are opposite to each other in their phases. FIGS. 14(a), 14(b), 14(c) and 14(d) show the signal P with a solid line and the signal N with a broken line.

Figure 14(e) shows a control signal set phase difference command value $\phi s^*$ between a set signal of the control signal Sigia and the control signal Sig2a and a set signal of the control signal Sig1b and the control signal Sig2b, and the control signal set phase difference command value $\phi s^*$ is variable.

Figure 14(f) shows that the control signal phase difference command value $\phi da^*$ of the control signal Sigia and the control signal Sig2a and the control signal phase difference command value $\phi db^*$ of the control signal Sig1b and the control signal Sig2b are fixed. Since the control signal phase difference command values $\phi da^*$, $\phi db^*$ are fixed, duty ratios Duty for gate signals for driving the amplifiers are also fixed (FIG. 14(g)).

Figures 14(h) and 14(i) show gate signal voltages Vgs1a, Vgs2a on the amplifier (AMP_UNITA) side, and FIGS. 14(j) and 14(k) show gate signal voltages Vgs1b, Vgs2b on the amplifier (AMP_UNITB) side. The pulse width of each voltage is fixed by a fixed value of a duty ratio DutyA or duty ratio DutyB. Reference letter DTA represents a dead time between the gate signal voltage Vgsia and the gate signal voltage Vgs2a, and reference letter DTB represents a dead time between the gate signa voltage Vgs1b and the gate signal voltage Vgs2b.

The control signal phase difference $\phi da$, $\phi db$ are used for setting the duty ratio DutyA for the gate signal voltages Vgs1a, Vgs2a and the duty ratio DutyB for the gate signal voltages Vgs1b, Vgs2b, respectively applied to the amplifiers, to fixed values that are the minimum duty ratio Duty_min which can be applied by a driver substrate.

Figure 14(l) shows a DC voltage Vdc that is defined by a manipulated variable $\alpha$ by the DC voltage control and is fixed because the DC voltage control is not performed on it.

The phase difference between the gate signal voltage Vgsia and the gate signal voltage Vgs1b is an amplifier output phase difference $\phi s^{amp}$ between the amplifier 2A and the amplifier 2B, and corresponds to the control signal set phase difference $\phi s$. The amplifier output phase difference $\phi s^{amp}$ is an angle according to a variable value of the control signal set phase difference command value $\phi s^*$.

4. Example of Parallel Connection

Figure 15 shows a configuration example in which the high-frequency power supply device shown in FIG. 1 is applied as one unit, and a plurality of units is connected in parallel.

The configuration example shown in Figure 15 connects a plurality of the high-frequency power supply devices of unit A to unit N in parallel. Each of the units A to N includes, as with the configuration shown in FIG. 1, drive circuits 3, amplifiers 2 and circulators/isolators 4. Control signals Sigia, Sig2a, Sig1b and Sig2b generated by a control signal generation unit 12 are distributed by a signal distributor 7 and supplied to the units A to N. The units A to N are controlled in the same way as the above-described control aspect. An amplifier output phase difference $\phi s^{amp}$ between two amplifiers output from each of the units A to N is a difference according to a control signal set phase difference command value $\phi s^*$.

A combiner 5 further combines amplifier outputs obtained by combining and performing the phase shift control in the respective units, so as to output a resultant high-frequency pulse output.

**Industrial Applicability**

The high-frequency power supply device and the output control method for a high-frequency pulse output of the present invention can be applied to industrial equipment that uses a pulse output of 1 kw or more with a frequency range of 27 MHz to 100 MHz, and can be used for industrial purposes, such as semiconductor manufacturing equipment, flat panel display (liquid crystal panel, organic panel) manufacturing equipment, solar panel manufacturing equipment, $CO_2$ laser processing machine.

**Reference Signs List**

1 High-Frequency Power Supply Device
2 Amplifier
2, 2A, 2B Amplifier
3, 3A, 3B Drive Circuit
4, 4A, 4B Circulator/Isolator
5 Combiner
6 DC Power Source
7 Signal Distributor
10 Power Control Unit
10a DC Voltage Computation Unit
10a1, 10b1 Power Controller
10b Phase Difference Computation Unit
11 DC Voltage Control Unit
12 Control Signal Generation Unit
12Aa, 12Ab, 12B Phase Difference Control Function Unit
A to N Unit
DT_min Minimum Necessary Dead Time
DT, DTA, DTB Dead Time
Duty_max Maximum Duty Ratio
Duty_min Minimum Duty Ratio
Duty, DutyA, DutyB Duty Ratio
FWD_ref* Output Power Command Value
FWD_FB Output Power Feedback Value
FWD Output Power
Gsigia, Gsig2a Gate Signal
Gsigib, Gsig2b Gate Signal
P, N Signal in Differential Signaling
$P_{out}$ Output Power
Sig1a, Sig2a Control Signal
Sig1b, Sig2b Control Signal
Siga, Sigb Set Signal
Vac Sine Wave Voltage
Vdc DC Voltage
Vdc_FB Feedback Voltage
Vdc_max Maximum Value
Vdc_min Minimum Value
Vdc* DC Voltage Command Value
Vdd Output Voltage Waveform
Vds Drain-to-Source Voltage
Vgs Gate Signal Voltage
Vgs1a, Vgs2a Gate Signal Voltage
Vgs1b, Vgs2b Gate Signal Voltage
Vref* DC Voltage Command Value
$\alpha$ Manipulated Variable
$\phi$ Phase Difference
$\phi$* Phase Difference Command Value
$\phi$d Control Signal Phase Difference
$\phi$d* Control Signal Phase Difference Command Value
$\phi$da Control Signal Phase Difference

$\phi$da* Control Signal Phase Difference Command Value
$\phi$db Control Signal Phase Difference
$\phi$db* Control Signal Phase Difference Command Value
$\phi$s Control Signal Set Phase Difference
$\phi$s* Control Signal Set Phase Difference Command Value
$\phi$s$^{amp}$ Amplifier Output Phase Difference

**Claims**

1. A high-frequency power supply device, comprising:

   a pair of amplifiers; and
   a combiner that combines amplifier outputs of the pair of the amplifiers to generate high-frequency pulse output power, wherein the high-frequency power supply device also comprising:

   a first control unit that perform DC voltage control for controlling a DC voltage Vdc to be supplied to the pair of the amplifiers to thereby control the output power;
   a second control unit that performs phase difference control on the output power by using phase difference $\phi$ between control signals used for controlling the amplifier outputs of the pair of the amplifiers,
   wherein the DC voltage control by the first control unit and the phase difference control by the second control unit are changed depending on an output level of the output power.

2. A high-frequency power supply device, comprising:

   a pair of amplifiers;
   a combiner that combines amplifier outputs of the pair of the amplifiers to generate high-frequency pulse output power;
   a power control unit that computes a DC voltage command value Vref* used for DC voltage control and a phase difference command value $\phi$* used for phase difference control in the control on the high-frequency pulse output power;
   a DC voltage control unit that performs the DC voltage control on a DC voltage Vdc to be supplied to the pair of the amplifiers based on the DC voltage command value Vref ; and
   a control signal generation unit that generates control signals to be used for the phase difference control on the pair of the amplifiers based on the phase difference command value $\phi$*,
   wherein the power control unit performs at an output level of the output power:

   (a) computation of the DC voltage command value Vref* for the DC voltage control in a range of high-output level; and
   (b) computation of the phase difference command value $\phi$* for the phase difference control in a range of low-output level,

   so as to change the DC voltage control and the phase difference control depending on the output level of the output power.

3. The high-frequency power supply device according to claim 2, wherein the control signals to be input to amplifiers are signals in differential signaling in a reverse-phase relation to each other.

4. The high-frequency power supply device according to claim 3, wherein the phase difference $\phi$ is a control signal phase difference $\phi$d between two pairs of the control signals to be input to the pair of the amplifiers,

   the power control unit computes a phase difference command value $\phi$d* between the control signals,
   the control signal generation unit

   performs control signal phase difference control to generate two pairs of the control signals with the control signal phase difference $\phi$d for each amplifier based on the phase difference command value $\phi$d*, and
   uses the control signals subjected to the control signal phase difference control for PWM control for controlling a duty ratio of a gate signal of a switching element of each amplifier to control the high-frequency pulse output power.

5. The high-frequency power supply device according to claim 3, wherein the phase difference $\phi$ includes a control signal phase difference $\phi d$ between the two pairs of the control signals to be input to each amplifier of the pair of the amplifiers and a control signal set phase difference $\phi s$ between signal sets to be input to each amplifier, each signal set consisting of the two pairs of the control signals to be input to each amplifier,

the power control unit computes a phase difference command value $\phi d^*$ between the control signals and a control signal set phase difference command value $\phi s^*$, and
the control signal generation unit changes a control mode between a high-output level side and a low-output level side in the low-output level range:

(a) to perform control signal phase difference control on the high-output level side to generate the two pairs of the control signals with the control signal phase difference $\phi d$ for each amplifier based on the phase difference command value $\phi d^*$, and
to control the high-frequency pulse output power by PWM control for controlling a duty ratio of a gate signal of a switching element of each amplifier, by using control signals subjected to the control signal phase difference control;
(b) to perform phase shift control on the low-output level side to generate a signal set of two pairs of the control signals with a control signal set phase difference $\phi s$ based on the control signal set phase difference command value $\phi s^*$ in the pair of the amplifiers, control a phase difference between the gate signals of the pair of the amplifiers by the signal set of the two pairs of the control signals performed the phase shift control, and control the high-frequency pulse output power by the phase difference between the gate signals; and
(c) to combine amplifier outputs of the pair of the amplifiers generated by the control signal phase difference control and the phase shift control to thereby generate a high-frequency pulse output.

6. The high-frequency power supply device according to claim 4 or 5, wherein the power control unit determines the control signal phase difference value $\phi d^*$ between the two pairs of the control signals to be input to each amplifier based on a comparison between an output power feedback value FWD_FB and an output power command value FWD_ref* for the high-frequency pulse output.

7. The high-frequency power supply device according to claim 4 or 5, wherein the power control unit adjusts the control signal phase difference command value $\phi d^*$ between the two pairs of the control signals in each amplifier based on a comparison between the amplifier outputs of the amplifiers, so as to balance the amplifier outputs of the pair of the amplifiers.

8. The high-frequency power supply device according to claim 4 or 5, wherein, in each amplifier of the pair of the amplifiers, the power control unit adjusts control signal phase difference command values $\phi da^*$ and $\phi da^*$ that equalize phase difference amounts between a first control signal phase difference $\phi da$ between two pairs of the control signals to be input to one of the amplifiers and a second control signal phase difference $\phi db$ between two pairs of the control signals to be input to the other amplifier.

9. The high-frequency power supply device according to claim 5, wherein the power control unit determines the control signal set phase difference command value $\phi s^*$ between the signal sets based on a comparison between an output power feedback value FWD_FB and an output power command value FWD_ref* of the high-frequency pulse output power.

10. The high-frequency power supply device according to claim 2, wherein the DC voltage control unit controls a DC output voltage in an AD/DC converter by using a manipulated variable $\alpha$ obtained based on a difference between a feedback voltage Vdc_FB of the DC voltage to be supplied to the amplifiers and the DC voltage command value Vref*.

11. The high-frequency power supply device according to any one of claims 1 to 9, wherein each amplifier is switching mode type power amplifier and is a series circuit formed by two switching elements operated by the control signals with the phase difference.

12. An output control method for high-frequency power for varying high-frequency pulse output power by controlling a pair of amplifiers, wherein
DC voltage control and phase difference control (CNTL2) are changed depending on an output level, so as to:

(a) control the output power by performing DC voltage control for controlling a DC voltage Vdc to be supplied to the pair of the amplifiers in a high-output level range of the output level; and
(b) control the output power by performing phase difference control for controlling a phase difference $\phi$ between control signals to be input to the pair of the amplifiers in a low-output level range of the output level.

13. The output control method for high-frequency power according to claim 12, wherein the control signals to be input to each amplifier are signals in differential signaling in a reverse-phase relation to each other.

14. The output control method for high-frequency power according to claim 13, wherein the phase difference $\phi$ is a control signal phase difference $\phi d$ between two pairs of the control signals to be input to each amplifier of the pair of the amplifiers, and
the phase difference control is for:

generating control signals each having a pulse width as the control signal phase difference $\phi d$; and
using the control signals to perform PWM control for controlling a duty ratio of a gate signal of each switching element of each amplifier, so as to control the high-frequency pulse output power.

15. The output control method for high-frequency power according to claim 13, wherein the phase difference $\phi$ includes a control signal phase difference $\phi d$ between the two pairs of the control signals to be input to each amplifier and a control signal set phase difference $\phi s$ between signal sets to be input to each amplifier, each signal set consisting of the two pairs of the control signals to be input to each amplifier,
the phase difference control changes a control mode between a high-output level side and a low-output level side in the low-output level range, and

(a) generates control signals each having a pulse width as the control signal phase difference $\phi d$ on the high-output level side, and uses the control signals to control the high-frequency pulse output power by PWM control for controlling a duty ratio of a gate signal of a switching element of each amplifier,
(b) generates control signals with a control signal set phase difference $\phi s$ between the signal set of the control signals on the low-output level side, and uses the control signals to control the high-frequency pulse output power by performing the phase shift control on the phase difference between the gate signals of the pair of the amplifiers; and
(c) combines amplifier outputs of the pair of the amplifiers to thereby generate a high-frequency pulse output.

16. The output control method for high-frequency power according to claim 14 or 15, wherein, in the phase difference control, the control signal phase difference command value $\phi d^*$ between the two pairs of the control signals to be input to each amplifier is determined based on a comparison between an output power feedback value FWD_FB and an output power command value FWD_ref* for the high-frequency pulse output.

17. The output control method for high-frequency power according to claim 14 or 15, wherein, in the phase difference control, the control signal phase difference command value $\phi d^*$ between the two pairs of the control signals in each amplifier is adjusted based on a comparison between the amplifier outputs of the amplifiers, so as to balance the amplifier outputs of the pair of the amplifiers.

18. The output control method for high-frequency power according to claim 14, wherein, in the phase difference control, in each amplifier of the pair of the amplifiers, control signal phase difference command values $\phi da^*$ and $\phi da^*$ that equalize phase difference amounts between a first control signal phase difference $\phi da$ between two pairs of the control signals to be input to one of the amplifiers and a second control signal phase difference $\phi db$ between two pairs of the control signals to be input to the other amplifier are adjusted.

19. The output control method for high-frequency power according to claim 15, wherein, in the phase shift control, the control signal set phase difference command value $\phi s^*$ between the signal sets is determined based on a comparison between an output power feedback value FWD_FB and an output power command value FWD_ref* of the high-frequency pulse output power.

20. The output control method for high-frequency power according to claim 12, wherein the DC voltage control is for controlling an output voltage based on a difference between a feedback voltage Vdc_FB of the DC voltage to be supplied to the amplifiers and the DC voltage command value Vref*.

FIG. 1

FIG. 2

(a)

Pout

| CONTROL ASPECT FOR CONTROL SIGNAL | CONTROL ASPECT FOR AMPLIFIER |

HIGH-OUTPUT LEVEL RANGE

Vdc_max
CNTL1 | DC VOLTAGE CONTROL | → VARIABLE OUTPUT
Vdc_min    DC VOLTAGE    Vdc

LOW-OUTPUT LEVEL RANGE

$\varphi$d, $\varphi$s FIXED

Duty FIXED

(b)

Pout

| CONTROL ASPECT FOR CONTROL SIGNAL | CONTROL ASPECT FOR AMPLIFIER |

HIGH-OUTPUT LEVEL RANGE

HIGH-OUTPUT LEVEL SIDE

PHASE DIFFERENCE CONTROL

Vdc_max
Vdc FIXED
Vdc_min

LOW-OUTPUT LEVEL RANGE

Duty_max

CNTL2d

| PWM CONTROL | ---→ | Duty CONTROL | → VARIABLE OUTPUT

$\varphi$da, $\varphi$db

DutyA=$\varphi$da/180deg
DutyB=$\varphi$db/180deg

Duty_min

LOW-OUTPUT LEVEL SIDE

CNTL2

CNTL2s
$\varphi$s FIXED

(c)

Pout

| CONTROL ASPECT FOR CONTROL SIGNAL | CONTROL ASPECT FOR AMPLIFIER |

HIGH-OUTPUT LEVEL RANGE

HIGH-OUTPUT LEVEL SIDE

PHASE DIFFERENCE CONTROL

Vdc_max
Vdc FIXED
Vdc_min

LOW-OUTPUT LEVEL RANGE

Duty_max

CNTL2d
$\varphi$da, $\varphi$db FIXED

Duty_min

LOW-OUTPUT LEVEL SIDE

CNTL2

CNTL2s

| PHASE SHIFT CONTROL | ---→ | PHASE SHIFT CONTROL | → VARIABLE OUTPUT
$\varphi$s         0°      $\varphi$s$^{amp}$

180°

FIG. 3

| | High | Low1 | Low2 | Zero | High |
|---|---|---|---|---|---|
| | DC VOLTAGE CONTROL | PHASE SHIFT CONTROL | | | DC VOLTAGE CONTROL |
| | | PWM CONTROL | PHASE SHIFT CONTROL | | |
| Vdc | VARIABLE | FIXED | FIXED | FIXED | VARIABLE |
| $\varphi s$ | FIXED | FIXED | VARIABLE (PHASE SHIFT) | FIXED | FIXED |
| $\varphi da, \varphi db$ | FIXED | VARIABLE (PWM) | FIXED (Duty_min) | FIXED | FIXED |

FIG. 4

(a)

| | High | Low1 | Low2 | Zero | High |
|---|---|---|---|---|---|

| | DC VOLTAGE CONTROL | PHASE SHIFT CONTROL | | | DC VOLTAGE CONTROL |
|---|---|---|---|---|---|
| | | PWM CONTROL | PHASE SHIFT CONTROL | | |
| Vdc | VARIABLE | FIXED | FIXED | FIXED | VARIABLE |
| φs | FIXED | FIXED | VARIABLE (PHASE SHIFT) | FIXED | FIXED |
| φda, φdb | FIXED | VARIABLE (PWM) | FIXED (Duty_min) | FIXED | FIXED |

(b)

| | High | Low1 | Low2 | Zero | High |
|---|---|---|---|---|---|

| | DC VOLTAGE CONTROL | PHASE SHIFT CONTROL | | | DC VOLTAGE CONTROL |
|---|---|---|---|---|---|
| | | PWM CONTROL | PHASE SHIFT CONTROL | | |
| Vdc | VARIABLE | FIXED | FIXED | FIXED | VARIABLE |
| φs | FIXED | FIXED | VARIABLE (PHASE SHIFT) | FIXED | FIXED |
| φda, φdb | FIXED | VARIABLE (PWM) | FIXED (Duty_min) | FIXED | FIXED |

FIG. 5

FIG. 6

FIG. 7

(a)

(b)

(c)

FIG. 8

FIG. 9

FIG. 10

FIG. 11

FIG. 12

DutyA=φda/180deg   DutyB=φdb/180deg

FIG. 13

FIG. 14

FIG. 15

## INTERNATIONAL SEARCH REPORT

International application No.

**PCT/JP2022/038814**

### A. CLASSIFICATION OF SUBJECT MATTER

*H02M 7/48*(2007.01)i; *H05H 1/46*(2006.01)i
FI:  H02M7/48 E; H05H1/46 R

According to International Patent Classification (IPC) or to both national classification and IPC

### B. FIELDS SEARCHED

Minimum documentation searched (classification system followed by classification symbols)

H02M7/42-7/98; H05H1/00-1/54; H03F1/00-3/72

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2016-4745 A (DAIHEN CORP) 12 January 2016 (2016-01-12) paragraphs [0034]-[0109], fig. 1-12 | 1-3, 10-13, 20 |
| A | | 4-9, 14-19 |
| A | JP 2015-144505 A (DAIHEN CORP) 06 August 2015 (2015-08-06) entire text, all drawings | 1-20 |
| A | JP 2015-533065 A (ETA DEVICES INC) 16 November 2015 (2015-11-16) entire text, all drawings | 1-20 |
| A | WO 2016/093269 A1 (DAIHEN CORP) 16 June 2016 (2016-06-16) entire text, all drawings | 1-20 |

☐ Further documents are listed in the continuation of Box C.      ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **01 December 2022** | **13 December 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/038814**

| Patent document cited in search report | | | Publication date (day/month/year) | Patent family member(s) | | | Publication date (day/month/year) |
|---|---|---|---|---|---|---|---|
| JP | 2016-4745 | A | 12 January 2016 | (Family: none) | | | |
| JP | 2015-144505 | A | 06 August 2015 | (Family: none) | | | |
| JP | 2015-533065 | A | 16 November 2015 | US entire text, all drawings WO | 2014/0120854 2014/070474 | A1 A1 | |
| WO | 2016/093269 | A1 | 16 June 2016 | US entire text, all drawings CN KR | 2017/0352523 107006113 10-2017-0093875 | A1 A A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015097812 W

- JP H637375 A